(19) Europäisches Patentamt / European Patent Office / Office européen des brevets

(11) EP 4 546 730 A1

(12) **EUROPEAN PATENT APPLICATION**
published in accordance with Art. 153(4) EPC

(43) Date of publication:
**30.04.2025 Bulletin 2025/18**

(21) Application number: **22954267.5**

(22) Date of filing: **08.08.2022**

(51) International Patent Classification (IPC):
***H04L 27/00*** *(2006.01)* ***H04L 1/00*** *(2006.01)*

(52) Cooperative Patent Classification (CPC):
**H04L 1/00; H04L 27/00**

(86) International application number:
**PCT/CN2022/110969**

(87) International publication number:
**WO 2024/031287 (15.02.2024 Gazette 2024/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Huawei Technologies Co., Ltd.**
**Shenzhen, Guangdong 518129 (CN)**

(72) Inventors:
- **TONG, Jiajie**
  **Shenzhen, Guangdong 518129 (CN)**
- **ZHANG, Huazi**
  **Shenzhen, Guangdong 518129 (CN)**
- **WANG, Xianbin**
  **Shenzhen, Guangdong 518129 (CN)**
- **LI, Rong**
  **Shenzhen, Guangdong 518129 (CN)**
- **WANG, Jun**
  **Shenzhen, Guangdong 518129 (CN)**

(74) Representative: **Körber, Martin Hans**
**Mitscherlich PartmbB**
**Patent- und Rechtsanwälte**
**Karlstraße 7**
**80333 München (DE)**

# (54) DATA PROCESSING METHOD AND APPARATUS, AND DEVICE

(57) This application provides a data processing method, an apparatus, and a device, so that an information bit construction and encoding method based on an allocation sequence is designed. According to the method, a quantity of information bits in each to-be-encoded sub-block in a to-be-encoded block may be determined based on a quantity of information bits and an allocation sequence, to implement information bit construction and encoding. The information bit construction method is simple and effective, and helps improve system performance and reduce system power consumption. In addition, information bit construction and rate matching when a length of a code sub-block is less than an integer multiple of $2^n$ can be supported in the method.

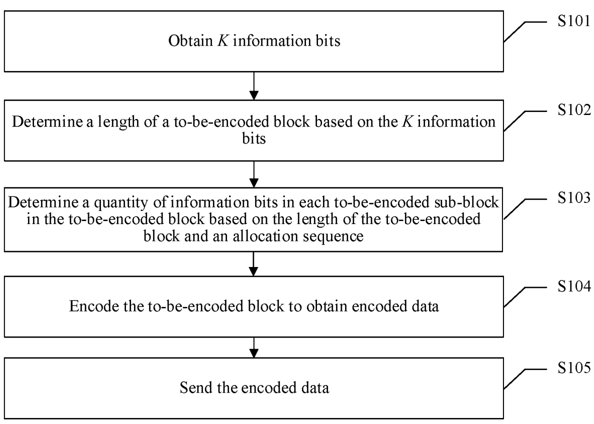


FIG. 6

EP 4 546 730 A1

## Description

### TECHNICAL FIELD

This application relates to the field of communication technologies, and in particular, to a data processing method, an apparatus, and a device.

### BACKGROUND

A polar code (Polar code) is a channel encoding scheme that can be strictly proved to "reach" a Shannon channel capacity, features good performance, low complexity, and the like, and may be applied to a 5th generation (5th generation, 5G) communication system and a future communication system. A mother code length of the polar code is an integer power of 2 (that is, $2^n$). When a code length $N$ required for actual communication is not the mother code length (for example, is not $2^n$), a code length matching process needs to be further implemented in a manner of puncturing, retransmission, and the like, to implement rate matching. For an ordinary polar code, an existing protocol standard specifies a sequence construction manner and a rate matching mode that is based on sub-block interleaving. However, the sequence construction manner is applicable only to an encoding matrix with the mother code length of $2^n$. Currently, for an encoding matrix without the mother code length of $2^n$, construction is performed only through Gaussian approximation and a quick and flexible construction method and a corresponding rate matching mode are absent.

### SUMMARY

This application provides a data processing method, an apparatus, and a device. According to the method, information bit construction and rate matching can be quickly performed on encoded data without a mother code length of an integer multiple of $2^n$. This construction method is simple and effective, and helps improve system performance.

According to a first aspect, this application provides a data processing method. The data processing method may be performed by a terminal device or a network device. An example in which the terminal device is an execution body and the terminal device is an encoding side is used. The terminal device obtains $K$ information bits, determines a length of a to-be-encoded block based on $K$, and determines a quantity of information bits in each to-be-encoded sub-block in the to-be-encoded block based on the length of the to-be-encoded block and an allocation sequence. The allocation sequence is used to describe quantities of information bits in all to-be-encoded sub-blocks except a last to-be-encoded sub-block in the to-be-encoded block in a case of a same code rate and a same to-be-encoded sub-block size. The terminal device encodes the to-be-encoded block to obtain encoded data, and sends the encoded data.

According to the method, an information bit construction and encoding method based on the allocation sequence is designed. The information bit construction method is simple and effective, and helps improve system performance and reduce system power consumption.

In a possible implementation, the length of the to-be-encoded block is $E=K/R$, where $R$ is a code rate;

the to-be-encoded block includes $m$ to-be-encoded sub-blocks, where $m=\left\lceil \frac{E}{N'} \right\rceil$;

the encoded data includes a code block, the code block includes $m$ code sub-blocks, and a size of the code sub-block is $N'$, where $N'=2^n$;

the allocation sequence includes $S$-1 variables $\{A_0,A_1,A_2,...,A_{S-2}\}$; and a relationship between elements in the allocation sequence is $A_0 \le A_1 \le ... \le A_{S-2}$.

According to the method, the length of the to-be-encoded block and a quantity of to-be-encoded sub-blocks in the to-be-encoded block are designed, so that a quantity of code sub-blocks is determined, and the size of the code sub-block is designed to be $2^n$. In this way, the code rate and the size of the code sub-block are fixed, to facilitate information bit construction that is based on the allocation sequence. The allocation sequence is further designed to support simpler information bit construction. In addition, information bit construction and rate matching when a length of the code sub-block is less than an integer multiple of $2^n$ can be supported in the method.

In a possible implementation, a length of each to-be-encoded sub-block is:

$$E_0 = E-(m-1)\times N',\text{ or }\; E_i = N',\text{ where }\; i \in \{1,2,...,m-2,m-1\}.$$

In a possible implementation, that the terminal device determines a quantity of information bits in each to-be-encoded sub-block in the to-be-encoded block based on the length of the to-be-encoded block and an allocation sequence may specifically include:

when $i = 0$, determining that a quantity of information bits in a 0th to-be-encoded sub-block is $J_0 = \frac{A_0 \times E_0}{N'} - \Delta_0$, where $A_0$ is a 0th element in the allocation sequence, and $\Delta_0$ is determined based on a difference between $E_0$ and $N'$, whose value is 0 or 1;

when $i = 1$, determining that a quantity of information bits in a 1st to-be-encoded sub-block is $J_1 = A_1 - \Delta_1$, where $A_1$ is a 1st element in the allocation sequence, and $\Delta_1$ is determined based on a difference between $E_0$ and $N'$, whose value is 0 or 1;

when $i \in \{2,3,...,m-2\}$, determining that a quantity of information bits in an $i$th to-be-encoded sub-block is $J_i = A_i$, where $A_i$ is an $i$th element in the allocation sequence; or

when $i = m-1$, determining that a quantity of information bits in an $(m-1)$th to-be-encoded sub-block is $J_{m-1} = K - \sum_{i=0}^{m-2} J_i$.

In the foregoing method, the length of the to-be-encoded sub-block and the quantity of information bits in each to-be-encoded sub-block in the to-be-encoded block are designed, so that information bit construction for an encoding matrix $G'$ can be supported.

In a possible implementation, a length of each to-be-encoded sub-block is: $E_{m-2} = E-(m-1)\times N'$, or $E_i = N'$, where $i \in \{0,1,2,...,m-3,m-1\}$.

In a possible implementation, that the terminal device determines a quantity of information bits in each to-be-encoded sub-block in the to-be-encoded block based on the length of the to-be-encoded block and an allocation sequence may specifically include:

when $i \in \{2,3,...,m-3\}$, determining that a quantity of information bits in an $i$th to-be-encoded sub-block is $J_i = A_i$, where $A_i$ is an $i$th element in the allocation sequence;

when $i = m-2$, determining that a quantity of information bits in an $(m-2)$th to-be-encoded sub-block is $J_{m-2} = \frac{A_{m-2} \times E_{m-2}}{N'} - \Delta_2$, where $A_{m-2}$ is an $(m-2)$th element in the allocation sequence, and $\Delta_2$ is determined based on a difference between $E_{m-2}$ and $N'$, whose value is 0 or 1; or

when $i = m-1$, determining that a quantity of information bits in an $(m-1)$th to-be-encoded sub-block is $J_{m-1} = K - \sum_{i=0}^{m-2} J_i$.

In the foregoing method, the length of the to-be-encoded sub-block and the quantity of information bits in each to-be-encoded sub-block in the to-be-encoded block are designed, so that information bit construction for an encoding matrix $G$ can be supported.

In a possible implementation, that the terminal device encodes the to-be-encoded block to obtain encoded data may specifically include:

dividing the $K$ information bits into $m$ segments based on information bit data of each to-be-encoded sub-block;

determining an information bit and a frozen bit of each code sub-block, and constructing an information sequence with a size of $m\times 2^n$ based on the quantity $m$ of code sub-blocks; and

inserting the $K$ information bits into a to-be-encoded sequence based on locations of information bits in the information sequence, and performing modulo two multiplication on the to-be-encoded sequence and an encoding matrix to obtain the encoded data.

In a possible implementation, the encoding matrix is
$$G=\begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix},$$

$G$ is a matrix with a size of $(m\times 2^n)\times(m\times 2^n)$, $m$ and $n$ are positive integers,
the matrix $G_{N'}$ is a polar generator matrix with a size of $2^n\times 2^n$, and
the matrix $O$ is an all-zero matrix with a size of $2^n\times 2^n$.

According to the method, a new encoding matrix $G$ for a polar code is designed. When the terminal device encodes the to-be-encoded information bits by using the encoding matrix $G$, after receiving a part of information bits in an encoding process, the terminal device may encode the part of information bits and send encoded data, to implement stream encoding and help reduce sizes of an encoder and a buffer in the terminal device.

In a possible implementation, when the encoded data (the encoded data is obtained based on the encoding matrix $G$) is sent, an $(m-1)^{\text{th}}$ to-be-encoded sub-block is first sent, and then an $i^{\text{th}}$ code sub-block is successively sent, where $i$ satisfies $0\le i\le m-2$.

According to the method, an order of sending the encoded data is designed, to facilitate stream decoding on a decoding side.

In a possible implementation, the encoding matrix is $G'=\begin{bmatrix} G_{N'} & O & \cdots & O \\ G_{N'} & G_{N'} & \cdots & O \\ \cdots & \cdots & \ddots & \cdots \\ G_{N'} & G_{N'} & \cdots & G_{N'} \end{bmatrix}$, $G'$ is a matrix with a size of $(m\times 2^n)\times(m\times 2^n)$, $m$ and $n$ are positive integers,

the matrix $G_{N'}$ is a polar generator matrix with a size of $2^n\times 2^n$, and
the matrix $O$ is an all-zero matrix with a size of $2^n\times 2^n$.

In a possible implementation, when the encoded data (the encoded data is obtained based on the encoding matrix $G'$) is sent, an $i^{\text{th}}$ code sub-block is successively sent, where $i$ satisfies $0\le i\le m-1$.

Optionally, the method in the first aspect may alternatively be performed by the network device. In this case, the network device is an encoding side, and the terminal device is a decoding side.

According to a second aspect, this application provides another data processing method. The data processing method may be performed by a terminal device or a network device. An example in which the network device is an execution body and the network device is a decoding side is used. The network device receives encoded data, and decodes the encoded data to obtain decoded data. The encoded data is obtained by encoding a to-be-encoded block. The to-be-encoded block includes a plurality of to-be-encoded sub-blocks. A quantity of information bits in each to-be-encoded sub-block in the to-be-encoded block is determined based on a length of the to-be-encoded block and an allocation sequence. The allocation sequence is used to describe quantities of information bits in all to-be-encoded sub-blocks except a last to-be-encoded sub-block in the to-be-encoded block in a case of a same code rate and a same to-be-encoded sub-block size.

According to the method, because the encoded data includes a plurality of code blocks, and quantities of information bits in the plurality of code blocks are designed according to a specific rule. In this case, stream decoding can be implemented for the encoded data.

In a possible implementation, the length of the to-be-encoded block is $E = K/R$ , where $R$ is a code rate;

the to-be-encoded block includes $m$ to-be-encoded sub-blocks, where $m=\left\lceil \frac{E}{N'} \right\rceil$;
the encoded data includes a code block, the code block includes $m$ code sub-blocks, and a size of the code sub-block is $N'$, where $N' = 2^n$;
the allocation sequence includes $S$-1 variables $\{A_0,A_1,A_2,...,A_{S-2}\}$; and a relationship between elements in the allocation sequence is $A_0\le A_1\le ...\le A_{S-2}$.

In a possible implementation, a length of each to-be-encoded sub-block is:

$$E_0 = E-(m-1)\times N' \text{, or } E_i = N' \text{, where } i\in\{1,2,...,m-2,m-1\}.$$

In a possible implementation, when $i$=0, a quantity of information bits in a $0^{\text{th}}$ to-be-encoded sub-block is

$J_0 = \frac{A_0 \times E_0}{N'} - \Delta_0$, where $A_0$ is a $0^{th}$ element in the allocation sequence, and $\Delta_0$ is determined based on a difference between $E_0$ and $N'$, whose value is 0 or 1;

when $i = 1$, a quantity of information bits in a $1^{st}$ to-be-encoded sub-block is $J_1 = A_1 - \Delta_1$, where $A_1$ is a $1^{st}$ element in the allocation sequence, and $\Delta_1$ is determined based on a difference between $E_0$ and $N'$, whose value is 0 or 1;
when $i \in \{2,3,...,m-2\}$, a quantity of information bits in an $i^{th}$ to-be-encoded sub-block is $J_i = A_i$, where $A_i$ is an $i^{th}$ element in the allocation sequence; or

when $i=m-1$, a quantity of information bits in an $(m-1)^{th}$ to-be-encoded sub-block is $J_{m-1} = K - \sum_{i=0}^{m-2} J_i$.

In a possible implementation, a length of each to-be-encoded sub-block is:

$$E_{m-2} = E - (m-1) \times N', \text{ or } E_i = N', \text{ where } i \in \{0,1,2,...,m-3,m-1\}.$$

In a possible implementation, when $i \in \{2,3,...,m-3\}$, a quantity of information bits in an $i^{th}$ to-be-encoded sub-block is $J_i = A_i$, where $A_i$ is an $i^{th}$ element in the allocation sequence; or

when $i=m-2$, a quantity of information bits in an $(m-2)^{th}$ to-be-encoded sub-block is $J_{m-2} = \frac{A_{m-2} \times E_{m-2}}{N'} - \Delta_2$, where $A_{m-2}$ is an $(m-2)^{th}$ element in the allocation sequence, and $\Delta_2$ is determined based on a difference between $E_{m-2}$ and $N'$, whose value is 0 or 1; or

when $i=m-1$, a quantity of information bits in an $(m-1)^{th}$ to-be-encoded sub-block is $J_{m-1} = K - \sum_{i=0}^{m-2} J_i$.

In a possible implementation, the encoded data is obtained by performing encoding by using an encoding matrix $G$, where the encoding matrix $G = \begin{bmatrix} G_{N'} & O & \cdots & O \\ O & G_{N'} & \cdots & O \\ \cdots & \cdots & \ddots & \cdots \\ G_{N'} & G_{N'} & \cdots & G_{N'} \end{bmatrix}$, $G$ is a matrix with a size of $(m \times 2^n) \times (m \times 2^n)$, $m$ and $n$ are positive integers, the matrix $G_{N'}$ is a polar generator matrix with a size of $2^n \times 2^n$, and the matrix $O$ is an all-zero matrix with a size of $2^n \times 2^n$.

In a possible implementation, that the network device decodes the encoded data to obtain decoded data may specifically include:

obtaining marked data corresponding to a $0^{th}$ receiving sub-block and marked data corresponding to a $1^{st}$ receiving sub-block, where the $0^{th}$ receiving sub-block is an $(m-1)^{th}$ code sub-block, and the $1^{st}$ receiving sub-block is a $0^{th}$ code sub-block;
performing an F operation on the marked data corresponding to the $0^{th}$ receiving sub-block and the marked data corresponding to the $1^{st}$ receiving sub-block, to obtain marked data corresponding to the $1^{st}$ receiving sub-block after the F operation;
performing polar code decoding on the marked data corresponding to the $1^{st}$ receiving sub-block after the F operation, to obtain decoded data corresponding to the $1^{st}$ receiving sub-block; and
enhancing, based on the marked data corresponding to the $1^{st}$ receiving sub-block and the decoded data corresponding to the $1^{st}$ receiving sub-block, the marked data corresponding to the $0^{th}$ receiving sub-block.

According to the method, the network device performs decoding based on the $0^{th}$ receiving sub-block that is received for the first time and the adjacent $1^{st}$ receiving sub-block, to implement stream decoding. In addition, the $0^{th}$ receiving sub-block is enhanced, which facilitates stream decoding based on the enhanced $0^{th}$ receiving sub-block in a subsequent decoding process.

In a possible implementation, the network device obtains marked data corresponding to a $q^{th}$ receiving sub-block, where the $q^{th}$ receiving sub-block is a $(q-1)^{th}$ code sub-block, and $q$ is $2 \le q \le m-1$; performs an F operation on the marked data corresponding to the $q^{th}$ receiving sub-block and enhanced marked data corresponding to the $0^{th}$ receiving sub-block, to obtain marked data corresponding to the $q^{th}$ receiving sub-block after the F operation; performs polar code decoding on the marked data corresponding to the $q^{th}$ receiving sub-block after the F operation, to obtain decoded data corresponding to the $q^{th}$ receiving sub-block; and enhances, based on the marked data corresponding to the $q^{th}$ receiving sub-block and the decoded data corresponding to the $q^{th}$ receiving sub-block, the enhanced marked data corresponding to the $0^{th}$ receiving sub-block.

According to the method, a $2^{nd}$ receiving sub-block to an $(m\text{-}1)^{th}$ receiving sub-block are decoded by using a same method. In addition, as decoding is performed, the marked data corresponding to the $0^{th}$ receiving sub-block is continuously enhanced, which facilitates stream decoding.

In a possible implementation, the encoded data is obtained by performing encoding by using an encoding matrix *G'*, where the encoding matrix

$$G'=\begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}$$

, *G'* is a matrix with a size of $(m\times 2^n)\times(m\times 2^n)$, *m* and *n* are positive integers, the matrix $G_{N'}$ is a polar generator matrix with a size of $2^n\times 2^n$, and the matrix *O* is an all-zero matrix with a size of $2^n\times 2^n$.

In a possible implementation, that the network device decodes the encoded data to obtain decoded data may specifically include:

obtaining marked data corresponding to a $0^{th}$ receiving sub-block and marked data corresponding to a $1^{st}$ receiving sub-block, where the $0^{th}$ receiving sub-block is a $0^{th}$ code sub-block, and the $1^{st}$ receiving sub-block is a $1^{st}$ code sub-block;
performing an F operation on the marked data corresponding to the $0^{th}$ receiving sub-block and the marked data corresponding to the $1^{st}$ receiving sub-block, to obtain marked data corresponding to the $0^{th}$ receiving sub-block after the F operation;
performing polar code decoding on the marked data corresponding to the $0^{th}$ receiving sub-block after the F operation, to obtain decoded data corresponding to the $0^{th}$ receiving sub-block; and
enhancing, based on the marked data corresponding to the $0^{th}$ receiving sub-block and the decoded data corresponding to the $0^{th}$ receiving sub-block, the marked data corresponding to the $1^{st}$ receiving sub-block.

In a possible implementation, the network device obtains marked data corresponding to a $p^{th}$ receiving sub-block, where the $p^{th}$ receiving sub-block is a $p^{th}$ code sub-block, and *p* is $2\leq p\leq m\text{-}1$; performs an F operation on the marked data corresponding to the $p^{th}$ receiving sub-block and enhanced marked data corresponding to a $(p\text{-}1)^{th}$ receiving sub-block, to obtain marked data corresponding to the $(p\text{-}1)^{th}$ receiving sub-block after the F operation; performs polar code decoding on the marked data corresponding to the $(p\text{-}1)^{th}$ receiving sub-block after the F operation, to obtain decoded data corresponding to the $(p\text{-}1)^{th}$ receiving sub-block; and enhances, based on the enhanced marked data corresponding to the $(p\text{-}1)^{th}$ receiving sub-block and the decoded data corresponding to the $(p\text{-}1)^{th}$ receiving sub-block, the marked data corresponding to the $p^{th}$ receiving sub-block.

Optionally, the method in the second aspect may alternatively be performed by the terminal device. In this case, the network device is an encoding side, and the terminal device is a decoding side.

According to a third aspect, an embodiment of this application provides a data processing apparatus. The data processing apparatus may be a terminal device, or may be an apparatus in the terminal device, or may be an apparatus that can be used with the terminal device. In a design, the data processing apparatus may include a one-to-one corresponding module for performing the method/operation/step/action described in the first aspect and the second aspect. The module may be a hardware circuit, or may be software, or may be implemented by a combination of a hardware circuit and software. In a design, the apparatus may include a processing unit and a transceiver unit.

For specific descriptions of the method/operation/step/action performed by the data processing apparatus, refer to the corresponding descriptions in the first aspect and the second aspect. Details are not described herein again. It may be understood that the data processing apparatus can also achieve effects that can be achieved in the first aspect and the second aspect.

According to a fourth aspect, an embodiment of this application provides a data processing apparatus. The data processing apparatus may be a network device, or may be an apparatus in the network device, or may be an apparatus that can be used with the network device. In a design, the data processing apparatus may include a one-to-one corresponding module for performing the method/operation/step/action described in the first aspect and the second aspect. The module may be a hardware circuit, or may be software, or may be implemented by a combination of a hardware circuit and software. In a design, the data processing apparatus may include a processing unit and a transceiver unit.

For specific descriptions of the method performed by the data processing apparatus, refer to the corresponding descriptions in the first aspect and the second aspect. Details are not described herein again. It may be understood that the data processing apparatus can also achieve effects that can be achieved in the first aspect and the second aspect.

According to a fifth aspect, an embodiment of this application provides a communication apparatus. The communication apparatus includes an input/output interface and a logic circuit. The input/output interface is configured to input or output data. The logic circuit processes the data according to the method in any one of the first aspect or the possible implementations of the first aspect, to obtain processed data.

According to a sixth aspect, an embodiment of this application provides a communication apparatus. The communication apparatus includes an input/output interface and a logic circuit. The input/output interface is configured to input or output data. The logic circuit processes the data according to the method in any one of the second aspect or the possible implementations of the second aspect, to obtain processed data.

According to a seventh aspect, an embodiment of this application provides a communication device, including a processor. The processor is coupled to a memory. The memory is configured to store instructions. When the instructions are executed by the processor, the terminal device is enabled to implement the method in any one of the possible implementations of the first aspect or the second aspect.

In a possible implementation, the communication device is a terminal device.

In another possible implementation, the communication device is a network device.

According to an eighth aspect, this application provides a communication system. The communication system includes one or more of the data processing apparatuses provided in the third aspect and the fourth aspect. Alternatively, the communication system includes the terminal device and the network device provided in the seventh aspect.

In a possible implementation, the communication system includes a transmitting end and a receiving end. The transmitting end is configured to perform the method in any one of the first aspect or the possible implementations of the first aspect. The receiving end is configured to perform the method in any one of the second aspect or the possible implementations of the second aspect.

According to a ninth aspect, this application provides a chip system. The chip system includes a processor, and may further include a memory, configured to implement the method in any one of the first aspect or the possible implementations of the first aspect, or the method in any one of the second aspect or the possible implementations of the second aspect. The chip system may include a chip, or may include a chip and another discrete component.

The interface in the chip may be an input/output interface, a pin, a circuit, or the like.

The chip system may be a system on chip (system on chip, SoC), or may be a baseband chip, or the like. The baseband chip may include a processor, a channel encoder, a digital signal processor, a modem, an interface module, and the like.

According to a tenth aspect, this application provides a computer-readable storage medium. The computer-readable storage medium stores a computer program. The computer program is executed by a processor to implement the method in any one of the first aspect or the possible implementations of the first aspect, or the method in any one of the second aspect or the possible implementations of the second aspect.

According to an eleventh aspect, this application provides a computer program product. The computer program product includes instructions. When the instructions are run on a computer, the computer is enabled to perform the method in any one of the first aspect or the possible implementations of the first aspect, or the method in any one of the second aspect or the possible implementations of the second aspect.

## BRIEF DESCRIPTION OF DRAWINGS

FIG. 1 is a diagram of a communication system according to this application;
FIG. 2 is a diagram of encoding a polar code of 8×8;
FIG. 3 is a diagram of calculating a log likelihood ratio LLR in a decoding process;
FIG. 4 is another diagram of calculating a log likelihood ratio LLR in a decoding process;
FIG. 5a is a diagram of a quantity of information bits in a code sub-block;
FIG. 5b is another diagram of a quantity of information bits in a code sub-block;
FIG. 6 is a schematic flowchart of a first data processing method according to this application;
FIG. 7 is a schematic flowchart of a second data processing method according to this application;
FIG. 8 is a performance analysis diagram of a data processing method according to this application;
FIG. 9 is a diagram of an apparatus according to this application; and
FIG. 10 is a diagram of a communication device according to this application.

## DESCRIPTION OF EMBODIMENTS

In this application, "/" may represent an "or" relationship between associated objects. For example, A/B may represent A or B. In addition, "and/or" may indicate that there are three relationships between associated objects. For example, A and/or B may represent the following three cases: Only A exists, both A and B exist, and only B exists, where A and B may be singular or plural. For ease of description of technical solutions of this application, in this application, terms such as "first" and "second" may be used to distinguish between technical features with same or similar functions. The terms such as "first" and "second" do not limit a quantity and an execution sequence, and the terms such as "first" and "second" do not limit a definite difference. In this application, the terms such as "example" or "for example" are used to represent an example, an illustration, or a description. Any embodiment or design scheme described as "example" or "for example" should not be explained as being more preferred or having more advantages than another embodiment or design scheme. The terms such as "example" or "for example" are used to present a related concept in a specific manner for ease of understanding.

The following describes the technical solutions of this application with reference to the accompanying drawings in this application.

This application provides a data processing method. According to the method, an information bit construction and encoding method based on an allocation sequence is designed. The data processing method may be applied to a communication system, and a system architecture is shown in FIG. 1. The communication system includes a network device and a terminal device, and the network device may provide a communication service for the terminal device.

The communication system mentioned in this application includes but is not limited to: a narrowband-internet of things (narrowband-Internet of things, NB-IoT) system, a global system for mobile communications (global system for mobile communications, GSM), an enhanced data rate for GSM evolution (enhanced data rate for GSM evolution, EDGE) system, a wideband code division multiple access (wideband code division multiple access, WCDMA) system, a code division multiple access 2000 (code division multiple access, CDMA2000) system, a time division-synchronization code division multiple access (time division-synchronization code division multiple access, TD-SCDMA) system, a long term evolution (long term evolution, LTE) system, three application scenarios of a 5G mobile communication system: enhanced mobile broadband (enhanced mobility broad band, eMBB), ultra-reliable and low-latency communications (ultra-reliable and low-latency communications, URLLC), and enhanced machine-type communication (enhanced machine-type communication, eMTC), and a future communication system (such as 6G/7G).

The network device may be a device that can communicate with the terminal device. The network device may be a base station, a relay station, or an access point. The base station may be a base transceiver station (base transceiver station, BTS) in a global system for mobile communications (global system for mobile communications, GSM) or a code division multiple access (code division multiple access, CDMA) network, or may be a 3G base station NodeB in a wideband code division multiple access (wideband code division multiple access, WCDMA) system, or may be an evolved NodeB (eNB or eNodeB for short) in a long term evolution (long term evolution, LTE) system. The network device may alternatively be a satellite in a satellite communication system. The network device may alternatively be a radio controller in a cloud radio access network (cloud radio access network, CRAN) scenario. The network device may alternatively be a network device in a 5G network or a network device (for example, a gNodeB) in a future evolved public land mobile network (public land mobile network, PLMN) network. The network device may alternatively be a wearable device, an uncrewed aerial vehicle, a device in the internet of vehicles (for example, a vehicle to everything (vehicle to everything, V2X) device), a communication device in device to device (device to device, D2D) communication, or a network device used in a future communication system.

The terminal device may be user equipment (user equipment, UE), an access terminal, a terminal unit, a terminal station, a mobile station, a remote station, a remote terminal, a mobile device, a terminal, a wireless communication device, a terminal agent, a terminal apparatus, or the like. The access terminal may be a cellular phone, a cordless phone, a session initiation protocol (session initiation protocol, SIP) phone, a wireless local loop (wireless local loop, WLL) station, a personal digital assistant (personal digital assistant, PDA), a handheld device with a wireless communication function, a computing device, another processing device connected to a wireless modem, a wearable device, an uncrewed aerial vehicle, a V2X device, a D2D device, a terminal device in the 5G network, a terminal device in the future evolved PLMN network, a terminal device in the future communication system, or the like.

It may be understood that this application includes an encoding scheme, and may be used for a dedicated network device or a general-purpose device, may be used for the network device, or may be used for various terminal devices or the like. This application may be implemented by using a dedicated chip (for example, an application-specific integrated circuit (application-specific integrated circuit, ASIC)), or may be implemented by using a programmable chip (for example, a field programmable gate array (field programmable gate array, FPGA)), or may be implemented by using software (program code in a memory). This is not limited in this application.

(1) Related concepts in this application

1. This application is based on polar code encoding:

A polar code is a channel encoding scheme that can be strictly proved to reach a channel capacity. The polar code features high performance, low complexity, a flexible matching manner, and the like. Currently, the polar code has been determined as an uplink and/or downlink control channel encoding scheme in a 5th generation mobile communication (5$^{th}$ generation, 5G) control channel enhanced mobile broadband (enhanced mobile broadband, eMBB) scenario.

For example, FIG. 2 is a diagram of encoding a polar code of 8×8. To-be-encoded bits are sorted based on reliability of the to-be-encoded bits, and are successively arranged at different locations in a to-be-encoded block. Generally, a bit with high reliability is set as an information bit (data), and a bit with low reliability is set as a frozen (frozen) bit. A value of the frozen bit is usually set to 0, and is known to both a transmitting end and a receiving end during actual transmission. As shown in FIG. 2, $u_7,u_6,u_5,u_3$ are four bits with higher reliability and are respectively set as information bits, and $u_4,u_2,u_1,u_0$ are four bits with lower reliability and are respectively set as frozen bits.

The polar code is a linear block code. A generator matrix of the polar code is $G_N$, and an encoding process of the polar code is $x_1^N = u_1^N G_N$. $u_1^N = (u_1, u_2, \ldots, u_N)$ is a binary row vector, and has a length of $N$ (that is, a code length). $G_N$ is a matrix of $N \times N$, and $G_N = F_2^{\otimes(\log_2(N))}$, where $F_2 = \begin{bmatrix} 1 & 0 \\ 1 & 1 \end{bmatrix}$, and $F_2^{\otimes(\log_2(N))}$ is defined as a Kronecker (Kronecker) product of $\log_2(N)$ matrices $F_2$. For example, when $N$=4, $\log_2(N) = \log_2(4) = 2$ and $F_2^{\otimes 2} = \begin{bmatrix} 1 & 0 & 0 & 0 \\ 1 & 1 & 0 & 0 \\ 1 & 0 & 1 & 0 \\ 1 & 1 & 1 & 1 \end{bmatrix}$; or when $N$=8, $\log_2(N) = \log_2(8) = 3$, and

$$F_2^{\otimes 3} = \begin{bmatrix} 1 & 0 & 0 & 0 & 0 & 0 & 0 & 0 \\ 1 & 1 & 0 & 0 & 0 & 0 & 0 & 0 \\ 1 & 0 & 1 & 0 & 0 & 0 & 0 & 0 \\ 1 & 1 & 1 & 1 & 0 & 0 & 0 & 0 \\ 1 & 0 & 0 & 0 & 1 & 0 & 0 & 0 \\ 1 & 1 & 0 & 0 & 1 & 1 & 0 & 0 \\ 1 & 0 & 1 & 0 & 1 & 0 & 1 & 0 \\ 1 & 1 & 1 & 1 & 1 & 1 & 1 & 1 \end{bmatrix}$$

. Therefore, a standard mother code length of the polar code is $N = 2^n$, where $n$ is a positive integer.

2. First encoding matrix $G$ of the polar code provided in this application:

The encoding matrix provided in this application is

$$G = \begin{bmatrix} G_{N'} & O & \ldots & O \\ O & G_{N'} & \ldots & O \\ \ldots & \ldots & \ddots & \ldots \\ G_{N'} & G_{N'} & \ldots & G_{N'} \end{bmatrix}$$

, where $G$ is a matrix with a size of $(m \times 2^n) \times (m \times 2^n)$, $m$ and $n$ are positive integers, the matrix $G_{N'}$ is a polar generator matrix with a size of $2^n \times 2^n$, and is represented as $G_{N'} = F_2^{\otimes(\log_2(N'))}$, and the matrix $O$ is an all-zero matrix with a size of $2^n \times 2^n$.

In other words, if the encoding matrix G is considered as a matrix of $m \times m$, each element in the matrix is a matrix of $2^n \times 2^n$, each element in a diagonal of the matrix is a matrix $G_{N'}$, each element in a bottom edge of the matrix is a matrix $G_{N'}$, and an element other than the elements in the diagonal and the bottom edge is a matrix $O$.

A mother code length of the encoding matrix $G$ is $N' = m \times 2^n$. It may be understood that when $m$=1 or $m$=2, the encoding matrix $G$ is the same as an encoding matrix of an ordinary polar code. When $m \geq 3$, the encoding matrix

$$G=\begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}.$$

3. Calculate a mean value change of a log likelihood ratio (log likelihood ratio, LLR) of each $G_{N'}$ based on the encoding matrix $G$:

After receiving encoded data obtained based on the encoding matrix $G$, a decoding side may decode the encoded data. For example, a decoding process is shown in FIG. 3. The decoding side may calculate the mean value change of the LLR of each $G_{N'}$ based on the encoding matrix $G$. It is assumed that a mean value of a receiving LLR is L on an additive white Gaussian noise (additive white Gaussian noise, AWGN) channel. As shown in FIG. 3, a Gaussian approximate function (Gaussian approximate function, GAF) may be used to calculate an LLR distribution mean value of each $G_{N'}$ after being decoupled from a last coupling sub-block. Therefore, an LLR mean value of each code sub-block (receiving sub-block) with a size of $G_{N'}$ when ordinary polar code decoding is performed may be calculated. The LLR mean value of each code sub-block with the size of $G_{N'}$ is shown in the following formula:

$$LLR=\begin{cases} \tilde{L}_i^{N'} = GAF\left(L,\left(i+1\right)\times L\right), i \in \{0,1,2,...,m-2\} \\ \tilde{L}_{m-1}^{N'} = m \times L \end{cases} \quad (1)$$

$\tilde{L}_i^{N'}$ is an LLR mean value of any code sub-block other than a last code sub-block in *m-1* code sub-blocks, and $\tilde{L}_{m-1}^{N'}$ is an LLR mean value of the last code sub-block. It can be learned that, other than the last code sub-block, capacities of the other *m-1* code sub-blocks are related only to sequence numbers *i* of the *m-1* code sub-blocks, and are unrelated to a total quantity *m* of code sub-blocks in a code block.

4. Second encoding matrix of the polar code provided in this application:

The encoding matrix provided in this application is $G'=\begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}$, where $G'$ is a matrix with a size of $(m\times 2^n)\times(m\times 2^n)$, $m$ and $n$ are positive integers, the matrix $G_{N'}$ is a polar generator matrix with a size of $2^n\times 2^n$, and is represented as $G_{N'} = F_2^{\otimes(\log_2(N'))}$, and the matrix $O$ is an all-zero matrix with a size of $2^n\times 2^n$.

In other words, if the encoding matrix G' is considered as a matrix of $m\times m$, each element in the matrix is a matrix of $2^n\times 2^n$, each element in a lower triangular area of the matrix is the matrix $G_{N'}$, and an element in the matrix except the lower triangular area is the matrix $O$. A mother code length of the encoding matrix Gis $N'=m\times 2^n$.

5. Calculate a mean value change of an LLR of each $G_{N'}$ based on a second encoding matrix:

After receiving encoded data obtained based on the encoding matrix $G'$, a decoding side may decode the encoded data. For example, a decoding process is shown in FIG. 4. The decoding side may calculate the mean value change of the LLR of each $G_{N'}$ based on the encoding matrix $G'$. It is assumed that a mean value of a receiving LLR is L on an AWGN channel. As shown in FIG. 4, a GAF may be used to calculate an LLR distribution mean value of each $G_{N'}$ after being decoupled from a last coupling sub-block. Therefore, an LLR mean value of each code sub-block (receiving sub-block) with a size of $G_{N'}$ when ordinary polar code decoding is performed may be calculated. The LLR mean value of each code sub-block with the size of $G_{N'}$ is shown in the following formula:

$$LLR=\begin{cases}\tilde{L}_i^{N'}=GAF\left(L,\left(i+1\right)\times L\right), i\in\left\{0,1,2,...,m-2\right\}\\ \tilde{L}_{m-1}^{N'}=m\times L\end{cases} \quad (1)$$

$\tilde{L}_i^{N'}$ is an LLR mean value of any code sub-block other than a last code sub-block in $m$-1 code sub-blocks, and $\tilde{L}_{m-1}^{N'}$ is an LLR mean value of the last code sub-block. It can be learned that, other than the last code sub-block, capacities of the other $m$-1 code sub-blocks are related only to sequence numbers $i$ of the $m$-1 code sub-blocks, and are unrelated to a total quantity $m$ of code sub-blocks in a code block.

6. Determine an information distribution result of each sub-block based on the mean value change of the LLR of each $G_{N'}$:

Based on the descriptions in the foregoing sections 2 to 5, regardless of whether the encoding matrix $G$ or the encoding matrix $G'$ is used, after an obtained encoding result undergoes a channel and before a sub-block is decoupled and decoded, LLR mean value distribution of each sub-block is shown in the formula (1). Capacities of all mutually corresponding sub-blocks/information bits reflected in respective decoding diagrams of the two encoding matrices are consistent based on a capacity calculation result, so that a same information construction method may be used.

In addition, based on the mean value of the code sub-block, other than the last code sub-block, the capacities of the other $m$-1 code sub-blocks are related only to the sequence numbers $i$ of the $m$-1 code sub-blocks, and are unrelated to the total quantity $m$ of code sub-blocks in the code block. Therefore, when a code rate and $N'$ are fixed, an information bit distribution result, of the code sub-block, that meets a specific rule may be obtained. For example, FIG. 5a shows a quantity of information bits in each code sub-block when $R$=1/8, $N'$=128, and a quantity of information bits is 32, 48, 64, ..., or 192. It can be learned that, as the quantity of information bits gradually increases, a quantity of code sub-blocks also gradually increases (for example, increases from 2 to 12). A first row in FIG. 5a indicates that $K$=32, $m$=2, there are two code sub-blocks, one information bit is allocated to a 1st code sub-block, and 31 information bits are allocated to a 2nd code sub-block. A second row indicates that $K$=48, $m$=3, there are three code sub-blocks, one information bit is allocated to a 1st code sub-block, four information bits are allocated to a 2nd code sub-block, and 43 information bits are allocated to a 3rd code sub-block; by analogy, as shown in FIG. 5a. For another example, FIG. 5b shows a quantity of pieces of information in each sub-block when $R$=1/8, $N'$=256, and an information length is 64, 96, 128, ..., or 384. It can be learned that, as the quantity of information bits gradually increases, a quantity of code sub-blocks also gradually increases (for example, increases from 2 to 12). A first row indicates that $K$=64, $m$=2, there are two code sub-blocks, five information bits are allocated to a 1st code sub-block, and 59 information bits are allocated to a 2nd code sub-block. A second row indicates that $K$=96, $m$=3, there are three code sub-blocks, four information bits are allocated to a 1st code sub-block, six information bits are allocated to a 2nd code sub-block, and 89 information bits are allocated to a 3rd code sub-block; by analogy, as shown in FIG. 5b. As shown in FIG. 5a and FIG. 5b, other than a last code sub-block, other code sub-blocks belonging to a same column are allocated with a same quantity of information bits or a difference of only one or two information bits. Therefore, an allocation sequence may be used to describe quantities of information bits in all code sub-blocks except the last code sub-block in the code block in a case of a same code rate and a same code sub-block size. It may be understood that, because a quantity of information bits included in a code sub-block and a quantity of information bits included in a to-be-encoded sub-block are the same, and lengths of the to-be-encoded sub-block and the code sub-block are also the same, the allocation sequence may also be used to describe quantities of information bits in all to-be-encoded sub-blocks except a last to-be-encoded sub-block in the to-be-encoded block in a case of a same code rate and a same to-be-encoded sub-block size.

7. F operation:

The F operation is a basic decoding operation of the polar code, and a predefined F function (f-function) is used for processing. Inputs of the F function are $L_0$ and $L_1$, and the F function may be simplified as:

$$f\left(L_0,L_1\right)=\left(\mathrm{sig}\left(L_0\right)\wedge\mathrm{sig}\left(L_1\right)?-1:1\right)*\left(\mathrm{abs}\left(L_0\right)>\mathrm{abs}\left(L_1\right)?\mathrm{abs}\left(L_1\right):\mathrm{abs}\left(L_0\right)\right)$$

sig indicates a sign operation. If an immediate number is greater than 0, a return value is 0. If an immediate number is not greater than 0, a return value is 1. abs indicates an absolute value operation. For example, it is assumed that there is encoded data $x_0$ and $x_{m-1}$ with a length of $N'$, an F operation is performed on $x_0$ and $x_{m-1}$, and signs of $x_0$ and $x_{m-1}$ are compared. If the signs are consistent, a value of the immediate number is 1. If the signs are not consistent, a value of the immediate number is -1.

8. G operation:

The G operation is a basic decoding operation of the polar code, and a predefined G function (g-function) is used for processing. Inputs of the G function are $L_0$, $L_1$, and a feedback value B, and the G function is $g(L_0,L_1,B)=(B=0)?L_1+L_0:L_1-L_0$.

(2) First data processing method provided in this application

FIG. 6 is a schematic flowchart of a first data processing method according to this application. The data processing method may be performed by a terminal device, or may be performed by a network device, an encoding procedure is mainly performed, and the following steps are included.

S101: Obtain *K* information bits.

S102: Determine a length of a to-be-encoded block based on the *K* information bits.

S103: Determine a quantity of information bits in each to-be-encoded sub-block in the to-be-encoded block based on the length of the to-be-encoded block and an allocation sequence.

The to-be-encoded block carries the K information bits. In this case, the length of the to-be-encoded block is $E=K/R$, and *R* is a code rate. The to-be-encoded block includes *m* to-be-encoded sub-blocks, and a size of the to-be-encoded sub-block is $N'=2^n$. In this case, $m=\left\lceil \frac{E}{N'} \right\rceil$. It may be understood that the to-be-encoded block corresponds to a code block, and the to-be-encoded sub-block corresponds to a code sub-block. In this case, the code block includes *m* code sub-blocks, and a size of the code sub-block is $N'=2^n$.

The allocation sequence is used to describe quantities of information bits in all to-be-encoded sub-blocks except a last to-be-encoded sub-block in the to-be-encoded block in a case of a same code rate and a same to-be-encoded sub-block size. For example, it is assumed that the allocation sequence includes *S*-1 variables $\{A_0,A_1,A_2,...,A_{S-2}\}$, and a relationship between elements in the allocation sequence is $A_0 \le A_1 \le ... \le A_{S-2}$. It may be understood that, when the code rate and *N'* are fixed, an information bit distribution result, of a code sub-block, that meets a specific rule may be obtained, for example, an information bit distribution result of a code sub-block shown in FIG. 5a and FIG. 5b, that is, each row in FIG. 5a and FIG. 5b may correspond to one allocation sequence. For example, based on FIG. 5a, when the code rate $R$=1/8, and $N'$=128 are fixed, assuming that the quantity *K* of information bits is 64, the allocation sequence is {1, 4, 5, 54} .

Specifically, the quantity of information bits in each to-be-encoded sub-block in the to-be-encoded block based on the length of the to-be-encoded block and the allocation sequence is determined in the following two manners.

Manner 1: If the allocated to-be-encoded block is encoded based on an encoding matrix *G*, a length of each to-be-encoded sub-block may be determined, as shown in the following formulas (2) and (3):

$$E_i = N', \text{ where } i \in \{0,1,2,...,m-3,m-1\} \quad (2)$$

$$E_{m-2} = E-(m-1)\times N' \quad (3)$$

*i* is a sequence number of the to-be-encoded sub-block, *m* is a total quantity of to-be-encoded blocks, *N'* is a size of the to-be-encoded block, and *E* is the length of the to-be-encoded block. In this application, it is assumed that when the to-be-encoded block is encoded to obtain encoded data, and the encoded data is sent, a last code sub-block is first sent (a penultimate code sub-block is finally sent), to facilitate stream decoding. In this manner, when the quantity of information bits in the to-be-encoded sub-block is designed, a penultimate to-be-encoded sub-block is considered as a last sub-block, and a length is a total length of the to-be-encoded block minus a sum of lengths of other to-be-encoded sub-blocks, as shown in the formula (3).

If the allocated to-be-encoded block is encoded based on the encoding matrix *G*, the quantity of information bits in each to-be-encoded sub-block may be determined, as shown in the following formulas (4) to (6):

$$J_i = A_i, \text{ where } i \in \{2,3,...,m-3\} \quad (4)$$

$$J_{m-2} = \frac{A_{m-2}\times E_{m-2}}{N'} - \Delta_2 \quad (5)$$

$$J_{m-1} = K - \sum_{i=0}^{m-2} J_i \quad (6)$$

$J_i$ is a quantity of information bits in an $i^{th}$ to-be-encoded sub-block, $A_i$ is an $i^{th}$ element in the allocation sequence, $A_{m-2}$ is an $(m-2)^{th}$ element in the allocation sequence, and $\Delta_2$ is determined based on a difference between a length $E_{m-2}$ of an $(m-2)^{th}$ to-be-encoded sub-block and $N'$, whose value is 0 or 1.

It can be learned from the foregoing formulas (4) to (6) that, a quantity of information bits in a to-be-encoded sub-block other than the last to-be-encoded sub-block and the penultimate to-be-encoded sub-block in the to-be-encoded block is equal to a variable value of a corresponding sequence number in the allocation sequence; a quantity of information bits in the penultimate to-be-encoded sub-block is determined based on a length of the to-be-encoded sub-block, a variable value of a penultimate sequence number in the allocation sequence, $N'$, $\Delta_2$, and another parameter value; and a quantity of information bits in the last to-be-encoded sub-block is equal to the total quantity $K$ of information bits minus a sum of quantities of information bits in other to-be-encoded sub-blocks. In other words, provided that the allocation sequence is determined, the quantity of information bits in each to-be-encoded sub-block may be determined simply and quickly, to help implement information bit construction more simply and quickly.

Manner 2: If the allocated to-be-encoded block is encoded based on an encoding matrix $G'$ or an encoding matrix $G$, a length of each to-be-encoded sub-block may be determined, as shown in the following formulas (7) and (8):

$$E_0 = E - (m-1) \times N' \quad (7)$$

$$E_i = N', \text{ where } i \in \{1, 2, ..., m-2, m-1\} \quad (8)$$

$i$ is a sequence number of the to-be-encoded sub-block, $m$ is a total quantity of to-be-encoded blocks, and $N'$ is a size of the to-be-encoded block. In this application, it is assumed that when the to-be-encoded block is encoded to obtain encoded data, and the encoded data is sent, a $0^{th}$ code sub-block is first sent, to facilitate stream decoding. In this manner, when the quantity of information bits in the to-be-encoded sub-block is designed, a $0^{th}$ to-be-encoded sub-block is considered as a last sub-block, and a length is a total length of the to-be-encoded block minus a sum of lengths of other to-be-encoded sub-blocks, as shown in the formula (7).

If the allocated to-be-encoded block is encoded based on the encoding matrix $G'$ or the encoding matrix $G$, the quantity of information bits in each to-be-encoded sub-block may be determined, as shown in the following formulas (9) to (12):

$$J_0 = \frac{A_0 \times E_0}{N'} - \Delta_0 \quad (9)$$

$$J_1 = A_1 - \Delta_1 \quad (10)$$

$$J_i = A_i, \text{ where } i \in \{2, 3, ..., m-2\} \quad (11)$$

$$J_{m-1} = K - \sum_{i=0}^{m-2} J_i \quad (12)$$

$J_i$ is a quantity of information bits in an $i^{th}$ to-be-encoded sub-block, $A_i$ is an $i^{th}$ element in the allocation sequence, and $\Delta_0$ is determined based on a difference between a length $E_0$ of the $0^{th}$ to-be-encoded sub-block and $N'$, whose value is 0 or 1, $\Delta_1$ is determined based on a difference between a length $E_0$ of the $0^{th}$ to-be-encoded sub-block and N', whose value is 0 or 1. When the allocation sequence is generated, the length $E_0$ of the $0^{th}$ to-be-encoded sub-block is full by default. If the length $E_0$ of the $0^{th}$ to-be-encoded sub-block is punctured much, an increased capacity of a $1^{st}$ to-be-encoded sub-block may be limited, and $E_1$ needs to be adjusted by using the parameter $\Delta_1$, where $\Delta_1$ is determined based on the difference between the length $E_0$ of the $0^{th}$ to-be-encoded sub-block and $N'$.

It can be learned from the foregoing formulas (9) to (12) that, a quantity of information bits in a to-be-encoded sub-block other than the last to-be-encoded sub-block, the $0^{th}$ to-be-encoded sub-block, and the $1^{st}$ to-be-encoded sub-block in the to-be-encoded block is equal to a variable value of a corresponding sequence number in the allocation sequence; a quantity of information bits in the $0^{th}$ to-be-encoded sub-block is determined based on a length of the to-be-encoded sub-block, a variable value of a 0th sequence number in the allocation sequence, $N'$, $\Delta_0$, and another parameter value; a quantity of information bits in the 1st to-be-encoded sub-block is determined based on a variable value of a 1st sequence number in the allocation sequence, $\Delta_1$, and another parameter value; and a quantity of information bits in the last to-be-encoded sub-block is equal to the total quantity $K$ of information bits minus a sum of quantities of information bits in other to-be-encoded sub-blocks. In other words, provided that the allocation sequence is determined, the quantity of information bits in each to-be-encoded sub-block may be determined simply and quickly, to help implement information bit construction more simply and quickly.

S104: Encode the to-be-encoded block to obtain the encoded data.

S105: Send the encoded data.

Encoding the to-be-encoded block to obtain the encoded data may include the following steps.

s11: Divide the $K$ information bits into $m$ segments based on information bit data of each to-be-encoded sub-block.

s12: Determine an information bit and a frozen bit of each code sub-block, and construct an information sequence with a size of $m \times 2^n$ based on the quantity $m$ of code sub-blocks.

s13: Insert the $K$ information bits into a to-be-encoded sequence based on locations of information bits in the information sequence, and perform modulo two multiplication on the to-be-encoded sequence and an encoding matrix to obtain the encoded data.

When different encoding matrices are used, obtained encoded data is different.

Manner 1: When the used encoding matrix is $G=\begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$, for detailed descriptions of the encoding matrix $G$, refer to the foregoing corresponding descriptions.

For example, for a code sub-block in any code block, a frozen location of $N'$ is determined based on a length of the code sub-block, and an information bit is constructed based on a sequence with a size of $N'$. Selection of the frozen bit may be specified in an existing protocol, or may be designed separately. This is not limited in this application. The information sequence $u^N = \{u_0, u_1, u_2, \dots, u_{N-1}\}$ with the size of $m \times 2^n$ may be constructed based on the information bit and the frozen bit of each code sub-block and the quantity $m$ of code sub-blocks, and modulo two multiplication is performed on the information sequence $u^N$ and the encoding matrix $G$, so that an obtained encoding result is

$$x^N = u^N \times \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}.$$

For another example, $u^N$ may be divided into $m$ segments $u_0^{N'}, u_1^{N'}, u_2^{N'}, \dots, u_{m-1}^{N'}$, and a length of each segment is $N'$. Modulo two multiplication is performed on each segment and $G_{N'}$ based on the encoding matrix $G$, and an obtained result is $y_i^{N'} = u_i^{N'} \times G_{N'}$, $i \in \{0,1,2\dots,m-1\}$, so that an obtained encoding result is

$$\begin{cases} x_i^{N'} = y_i^{N'} \times y_{m-1}^{N'}, i \in \{0,1,2\dots,m-2\} \\ x_{m-1}^{N'} = y_{m-1}^{N'} \end{cases}.$$

In the manner 1, after the encoded data is generated, the encoded data is sent, where an order of sending the encoded data may be:

first sending an $(m-1)^{th}$ to-be-encoded sub-block; and

successively sending an $i^{th}$ code sub-block, where $0 \le i \le m-2$.

It may be understood that the order of sending the encoded data is used to facilitate stream decoding on a decoding side.

Manner 2: When the used encoding matrix is $G' = \begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}$, for detailed descriptions of the encoding matrix *G'* , refer to the foregoing corresponding descriptions.

For example, for a code sub-block in any code block, a frozen location of *N'* is determined based on a length of the code sub-block, and an information bit is constructed based on a sequence with a size of *N'*. Selection of the frozen bit may be specified in an existing protocol, or may be designed separately. This is not limited in this application. The information sequence $u^N = \{u_0, u_1, u_2, \dots, u_{N-1}\}$ with the size of $m \times 2^n$ may be constructed based on the information bit and the frozen bit of each code sub-block and the quantity *m* of code sub-blocks, and modulo two multiplication is performed on the information sequence $u^N$ and the encoding matrix *G*, so that an obtained encoding result is

$$x^N = u^N \times \begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}.$$

For another example, $u^N$ may be divided into *m* segments $u_0^{N'}, u_1^{N'}, u_2^{N'}, \dots, u_{m-1}^{N'}$, and a length of each segment is *N'*. Modulo two multiplication is performed on each segment and $G_{N'}$ based on the encoding matrix *G'*, and an obtained result is $y_i^{N'} = u_i^{N'} \times G_{N'}$, $i \in \{0,1,2...,m-1\}$. Adjacent data is coupled successively from back to front (for example, from (m-2)$^{th}$ data to 0$^{th}$ data successively from back to front), so that an obtained encoding result is

$$\begin{cases} x_i^{N'} = y_i^{N'} \times x_{i+1}^{N'}, i \in \{0,1,2...,m-2\} \\ x_{m-1}^{N'} = y_{m-1}^{N'} \end{cases}.$$

In the manner 2, after the encoded data is generated, the encoded data is sent, where an order of sending the encoded data may be:

successively sending an $i^{th}$ code sub-block, where $0 \le i \le m-1$.

It can be learned that, in the first data processing method provided in this application, an information bit construction and encoding method based on the allocation sequence is designed. The information bit construction method is simple and effective, and helps improve system performance and reduce system power consumption. In addition, information bit construction and rate matching when a length of the code sub-block is less than an integer multiple of $2^n$ can be supported in the method. In addition, the to-be-encoded information bits are encoded by using the encoding matrix *G*, to obtain the encoded data, which facilitates stream decoding.

(3) Second data processing method provided in this application

FIG. 7 is a schematic flowchart of a second data processing method according to this application. The data processing method may be performed by a terminal device, or may be performed by a network device. It may be understood that when the terminal device performs the data processing method described in the third part herein, that is, the terminal device is a decoding side, the network device performs the data processing method described in the second part, that is, the network device is an encoding side. When a decoding procedure is performed, the following steps are included.

S201: Receive encoded data, where the encoded data is obtained by encoding a to-be-encoded block.

The to-be-encoded block includes a plurality of to-be-encoded sub-blocks. A quantity of information bits in each to-be-encoded sub-block in the to-be-encoded block is determined based on a length of the to-be-encoded block and an allocation sequence. The allocation sequence is used to describe quantities of information bits in all to-be-encoded sub-blocks except a last to-be-encoded sub-block in the to-be-encoded block in a case of a same code rate and a same to-be-encoded sub-block size.

For descriptions of the to-be-encoded block, the to-be-encoded sub-block, a code block, a code sub-block, a quantity of information bits in the to-be-encoded block, the allocation sequence, and how to encode the to-be-encoded block, refer to the corresponding descriptions in the second part. Details are not described herein again. For example, to support stream decoding, the encoded data may be obtained by encoding an information bit sequence based on an encoding matrix $G$.

S202: Decode the encoded data to obtain decoded data.

When the encoded data is obtained by using different encoding matrices, corresponding decoding procedures are different, and the following two cases are included.

Case 1: If the encoded data is obtained by performing encoding by using the encoding matrix $G$, a process of decoding the encoded data is a stream decoding procedure, and the terminal device may first decode a received $0^{th}$ receiving sub-block and a received $1^{st}$ receiving sub-block. In other words, after receiving a part of information in the decoding process, the terminal device can decode the part of information. Specifically, the following steps may be included.

s11: Obtain marked data corresponding to the $0^{th}$ receiving sub-block and marked data corresponding to the $1^{st}$ receiving sub-block, where the $0^{th}$ receiving sub-block is an $(m\text{-}1)^{th}$ code sub-block, and the $1^{st}$ receiving sub-block is a $0^{th}$ code sub-block.

s12: Perform an F operation on the marked data corresponding to the $0^{th}$ receiving sub-block and the marked data corresponding to the $1^{st}$ receiving sub-block, to obtain marked data corresponding to the $1^{st}$ receiving sub-block after the F operation.

s13: Perform polar code decoding on the marked data corresponding to the $1^{st}$ receiving sub-block after the F operation, to obtain decoded data corresponding to the $1^{st}$ receiving sub-block.

s14: Enhance, based on the marked data corresponding to the $1^{st}$ receiving sub-block and the decoded data corresponding to the $1^{st}$ receiving sub-block, the marked data corresponding to the $0^{th}$ receiving sub-block.

The marked data corresponding to the $0^{th}$ receiving sub-block is a log likelihood ratio (log likelihood ratio, LLR) of the $0^{th}$ receiving sub-block, that is, an LLR of the $(m\text{-}1)^{th}$ code sub-block. The marked data corresponding to the $1^{st}$ receiving sub-block is an LLR of the $1^{st}$ receiving sub-block, that is, an LLR of the $0^{th}$ code sub-block. The LLR of the $0^{th}$ receiving sub-block and the LLR of the $1^{st}$ receiving sub-block are used as inputs of an F function, to obtain the marked data (that is, decouple encoded data received later) corresponding to the $1^{st}$ receiving sub-block after the F operation. For descriptions of the F function, refer to the foregoing descriptions. Details are not described herein again.

For a method for performing polar code decoding on the marked data corresponding to the $1^{st}$ receiving sub-block after the F operation, refer to an existing polar code decoding scheme. This is not limited in this application. The LLR of the $0^{th}$ receiving sub-block, the LLR of the $1^{st}$ receiving sub-block, and the decoded data corresponding to the $1^{st}$ receiving sub-block are used as inputs of a G function, to enhance the marked data corresponding to the $0^{th}$ receiving sub-block (that is, enhance encoded data received first), and facilitate stream decoding based on the enhanced $0^{th}$ receiving sub-block in a subsequent decoding process. For descriptions of the G function, refer to the foregoing descriptions. Details are not described herein again.

Optionally, the marked data corresponding to the $0^{th}$ receiving sub-block may be a likelihood probability of the $0^{th}$ receiving sub-block, and the marked data corresponding to the $1^{st}$ receiving sub-block may be a likelihood probability of the $1^{st}$ receiving sub-block. In this case, the foregoing step s12 is changed to: performing a probability operation on the marked data corresponding to the $0^{th}$ receiving sub-block and the marked data corresponding to the $1^{st}$ receiving sub-block, to obtain marked data corresponding to the $1^{st}$ receiving sub-block in a probability domain. It may be understood that a subsequent processing procedure is still performed according to s13 and s14, and the marked data corresponding to the $0^{th}$ receiving sub-block can be enhanced.

Further, for each subsequently received receiving sub-block, a processing manner is similar to that of s11 to s14, and may include the following steps.

s15: Obtain marked data corresponding to a $q^{th}$ receiving sub-block, where $q$ is $2 \leq q \leq m\text{-}1$, and the $q^{th}$ receiving sub-block is a $(q\text{-}1)^{th}$ code sub-block.

s16: Perform an F operation on the marked data corresponding to the $q^{th}$ receiving sub-block and enhanced marked data corresponding to the $0^{th}$ receiving sub-block, to obtain marked data corresponding to the $q^{th}$ receiving sub-block after the F operation.

s17: Perform polar code decoding on the marked data corresponding to the $q^{th}$ receiving sub-block after the F operation, to obtain decoded data corresponding to the $q^{th}$ receiving sub-block.

s18: Enhance, based on the marked data corresponding to the $q^{th}$ receiving sub-block and the decoded data corresponding to the $q^{th}$ receiving sub-block, the enhanced marked data corresponding to the $0^{th}$ receiving sub-block.

For example, marked data corresponding to a $2^{nd}$ receiving sub-block is obtained; an F operation is performed on the marked data corresponding to the $2^{nd}$ receiving sub-block and enhanced marked data corresponding to a $0^{th}$ receiving sub-block, to obtain marked data corresponding to the $2^{nd}$ receiving sub-block after the F operation; polar code decoding is performed on the marked data corresponding to the $2^{nd}$ receiving sub-block after the F operation, to obtain decoded data corresponding to the $2^{nd}$ receiving sub-block; and secondary enhancement is performed, based on the marked data corresponding to the $2^{nd}$ receiving sub-block and the decoded data corresponding to the $2^{nd}$ receiving sub-block, on the enhanced marked data corresponding to the $0^{th}$ receiving sub-block, to obtain marked data corresponding to the $0^{th}$ receiving sub-block after the secondary enhancement. For specific implementations of the foregoing steps, refer to specific implementations corresponding to s11 to s14. Details are not described herein again.

Case 2: If the encoded data is obtained by performing encoding by using an encoding matrix *G'*, a process of decoding the encoded data may include the following steps.

s21: Obtain marked data corresponding to a $0^{th}$ receiving sub-block and marked data corresponding to a $1^{st}$ receiving sub-block, where the $0^{th}$ receiving sub-block is a $0^{th}$ code sub-block, and the $1^{st}$ receiving sub-block is a $1^{st}$ code sub-block.

s22: Perform an F operation on the marked data corresponding to the $0^{th}$ receiving sub-block and the marked data corresponding to the $1^{st}$ receiving sub-block, to obtain marked data corresponding to the $0^{th}$ receiving sub-block after the F operation.

s23: Perform polar code decoding on the marked data corresponding to the $0^{th}$ receiving sub-block after the F operation, to obtain decoded data corresponding to the $0^{th}$ receiving sub-block.

s24: Enhance, based on the marked data corresponding to the $0^{th}$ receiving sub-block and the decoded data corresponding to the $0^{th}$ receiving sub-block, the marked data corresponding to the $1^{st}$ receiving sub-block.

The marked data corresponding to the $0^{th}$ receiving sub-block is an LLR of the $0^{th}$ receiving sub-block, and the marked data corresponding to the $1^{st}$ receiving sub-block is an LLR of the $1^{st}$ receiving sub-block. The LLR of the $0^{th}$ receiving sub-block and the LLR of the $1^{st}$ receiving sub-block are used as inputs of an F function, to obtain the marked data (that is, decouple encoded data received first) corresponding to the $0^{th}$ receiving sub-block after the F operation. For descriptions of the F function, refer to the foregoing descriptions. Details are not described herein again.

For a method for performing polar code decoding on the marked data corresponding to the $0^{th}$ receiving sub-block after the F operation, refer to an existing polar code decoding scheme. This is not limited in this application. The LLR of the $1^{st}$ receiving sub-block, the LLR of the $0^{th}$ receiving sub-block, and the decoded data corresponding to the $0^{th}$ receiving sub-block are used as inputs of a G function, to enhance the marked data corresponding to the $1^{st}$ receiving sub-block (that is, enhance encoded data received later). For descriptions of the G function, refer to the foregoing descriptions. Details are not described herein again.

Optionally, the marked data corresponding to the $0^{th}$ receiving sub-block may be a likelihood probability of the $0^{th}$ receiving sub-block, and the marked data corresponding to the $1^{st}$ receiving sub-block may be a likelihood probability of the $1^{st}$ receiving sub-block. In this case, the foregoing step s22 is changed to: performing a probability operation on the marked data corresponding to the $0^{th}$ receiving sub-block and the marked data corresponding to the $1^{st}$ receiving sub-block, to obtain the marked data corresponding to the $0^{th}$ receiving sub-block in a probability domain. It may be understood that a subsequent processing procedure is still performed according to s23 and s24, and the marked data corresponding to the $1^{st}$ receiving sub-block can be enhanced.

Further, for each subsequently received receiving sub-block, a processing manner is similar to that of s21 to s24, and may include the following steps.

s25: Obtain marked data corresponding to a $p^{th}$ receiving sub-block, where $p$ is $2 \le p \le m-1$, and the $p^{th}$ receiving sub-block is a $p^{th}$ code sub-block.

s26: Perform an F operation on the marked data corresponding to the $p^{th}$ receiving sub-block and enhanced marked data corresponding to a $(p-1)^{th}$ receiving sub-block, to obtain marked data corresponding to the $(p-1)^{th}$ receiving sub-block after the F operation.

s27: Perform polar code decoding on the marked data corresponding to the $(p-1)^{th}$ receiving sub-block after the F operation, to obtain decoded data corresponding to the $(p-1)^{th}$ receiving sub-block.

s28: Enhance, based on the enhanced marked data corresponding to the $(p-1)^{th}$ receiving sub-block and the decoded data corresponding to the $(p-1)^{th}$ receiving sub-block, the marked data corresponding to the $p^{th}$ receiving sub-block.

For example, marked data corresponding to a $2^{nd}$ receiving sub-block is obtained; an F operation is performed on the marked data corresponding to the $2^{nd}$ receiving sub-block and enhanced marked data corresponding to a $1^{st}$ receiving sub-block, to obtain marked data corresponding to the $1^{st}$ receiving sub-block after the F operation; polar code decoding is performed on the marked data corresponding to the $1^{st}$ receiving sub-block after the F operation, to obtain decoded data corresponding to the $1^{st}$ receiving sub-block; and the marked data corresponding to the $2^{nd}$ receiving sub-block is enhanced based on the marked data corresponding to the $1^{st}$ receiving sub-block and the decoded data corresponding to the $1^{st}$ receiving sub-block, to obtain enhanced marked data corresponding to the $2^{nd}$ receiving sub-block. For specific implementations of the foregoing steps, refer to specific implementations corresponding to s21 to s24. Details are not described herein again.

It can be learned that, in the data processing method provided in this application, after the encoded data is received, decoding of a part of information may be supported after receiving the part of information in the decoding process, to implement stream decoding, reduce a size of a decoder, and further reduce overheads of the decoding side.

(4) Performance analysis of a data processing method provided in this application applied to a decoding scenario:

FIG. 8 is a performance analysis diagram of a data processing method according to this application. The performance analysis diagram is a diagram of decoding performance obtained by using a simulation decoder with a code length of *N'* = {128, 256, 512} and a code rate of *R*=1/8. A horizontal coordinate of the performance analysis diagram is EsN0 and indicates a ratio of energy of each symbol to a noise power spectral density, and a vertical coordinate is a block error rate (block error rate, BLER), used to measure a system performance test. For example, when *N'*=128 and *R*=1/8, it is assumed that an allocation sequence is *A*={1,4,5,6,6,8,9,9,10,10,10}; or when *N'*=256 and *R*=1/8, it is assumed that an allocation sequence is *A*={3,6,10,13,16,17,18,19,20,21,21}. In addition, it is assumed that $\Delta_0$=1 and $\Delta_1$=1.

A solid line with a circular symbol, a dashed line with an asterisk, and a dashed line with a square symbol form a group, and may be used to compare differences in decoding performance when decoders with different sizes and different decoding schemes are used for different quantities of information bits.

1. The solid line with the circular symbol, the dashed line with the asterisk, and the dashed line with the square symbol are a group of decoding performance comparison, as shown in (1) in FIG. 8. It is assumed that a quantity of information bits is *K* = 48, and a sending length is *E*=*K*/*R*=48/(1/8)=384. It is assumed that a decoder size is 128, 256, or 512, and a decoding scheme is existing polar code decoding or stream decoding provided in this application. For example, the solid line with the circular symbol indicates decoding performance when the decoder size is 128, the quantity of information bits is *K*=48, a quantity of code sub-blocks in this case is 3, and stream decoding provided in this application is used; the dashed line with the asterisk indicates decoding performance when the decoder size is 512, the quantity of information bits is *K*=48, and ordinary polar code decoding is used; and the dashed line with the square symbol indicates decoding performance when the decoder size is 256, the quantity of information bits is *K*=48, and ordinary polar code decoding is used. It can be learned from comparison of the foregoing performance that the dashed line with the asterisk indicates a decoding result of the decoder size being 512. Because a maximum decoding length can support 512 (512 is greater than the sending length 384), segmentation is not performed. Therefore, performance is slightly better than decoding performance indicated by the solid line with the circular symbol in this application. However, the decoder size is twice that in this application. This application significantly reduces decoding-side overheads. The dashed line with the square symbol indicates a decoding result of the decoder size being 256. Because a maximum decoding length can support 256 (256 is less than the sending length 384), division into two segments is performed. Therefore, performance is poorer than decoding performance indicated by the solid line with the circular symbol in this application.
2. The solid line with the circular symbol, the dashed line with the asterisk, and the dashed line with the square symbol are a group of decoding performance comparison, as shown in (6) in FIG. 8. It is assumed that a quantity of information bits in an information bit sequence is *K*=88, and a sending length is *E*=*K*/*R*=88/(1/8)=704. It is assumed that a decoder size is 128, 256, or 512, and a decoding scheme is existing polar code decoding or stream decoding provided in this application. For example, the solid line with the circular symbol indicates decoding performance when the decoder size is 128, the quantity of information bits is *K*=88, and stream decoding in this application is used. In this case, a code length is not an integer multiple of the decoder size, and rate matching (for example, puncturing processing is performed, and 64 bit locations are punctured) may be performed on a 1$^{st}$ code sub-block. The dashed line with the asterisk indicates decoding performance when the decoder size is 512, the quantity of information bits is *K*=88, and ordinary polar code decoding is used; and the dashed line with the square symbol indicates decoding performance when the decoder size is 256, the quantity of information bits is *K*=88, and ordinary polar code decoding is used. It can be learned from comparison of the foregoing performance that the dashed line with the asterisk indicates a decoding result of the decoder size being 512. Because a maximum decoding length can support 512 (512 is less than the sending length 704), division into two segments is performed. Therefore, performance is poorer than decoding performance indicated by the solid line with the circular symbol in this application, and the decoder size is twice that in this application. This application significantly reduces decoding-side overheads. The dashed line with the square symbol indicates a decoding result of the decoder size being 256. Because a maximum decoding length can support 256 (256 is less than the sending length 704), division into three segments is performed. Therefore, performance is poorer than decoding performance indicated by the solid line with the circular symbol in this application.

It may be understood that, for performance analysis in other sub-diagrams (2) to (5) in FIG. 8, refer to the performance analysis in the foregoing two sections. Details are not described herein again.

To implement the functions in the methods provided in this application, the apparatus or the device provided in this application may include a hardware structure and/or a software module, and implement the foregoing functions in a form of the hardware structure, the software module, or a combination of the hardware structure and the software module. Whether a function in the foregoing functions is performed by using the hardware structure, the software module, or the combination of the hardware structure and the software module depends on particular applications and design constraints of the technical solutions. Division into modules in this application is an example, and is merely logical function division. During actual implementation, another division manner may be used. In addition, functional modules in embodiments of this application may be integrated into one processor, or may exist alone physically, or two or more modules may be integrated into one module. The integrated module may be implemented in a form of hardware, or may be implemented in a form of a software functional module.

FIG. 9 is a diagram of an apparatus according to this application. The apparatus may include a one-to-one corresponding module for performing the methods/operations/steps/actions described in the method embodiments corresponding to FIG. 3 to FIG. 7. The module may be a hardware circuit, or may be software, or may be implemented by a combination of a hardware circuit and software. For example, the apparatus may be referred to as a data processing apparatus, or may be referred to as a communication apparatus.

The apparatus includes a communication unit 901 and a processing unit 902, configured to implement the method performed by the terminal device or the network device in the foregoing embodiments.

In a possible implementation, the communication unit 901 is configured to obtain $K$ information bits, and the processing unit 902 is configured to determine a length of a to-be-encoded block based on $K$, and determine a quantity of information bits in each to-be-encoded sub-block in the to-be-encoded block based on the length of the to-be-encoded block and an allocation sequence. The allocation sequence is used to describe quantities of information bits in all to-be-encoded sub-blocks except a last to-be-encoded sub-block in the to-be-encoded block in a case of a same code rate and a same to-be-encoded sub-block size. The processing unit 902 is configured to encode the to-be-encoded block to obtain encoded data, and the communication unit 901 is configured to send the encoded data.

Optionally, the length of the to-be-encoded block is $E=K/R$, where $R$ is a code rate;

the to-be-encoded block includes $m$ to-be-encoded sub-blocks, where $m=\left\lceil \frac{E}{N'} \right\rceil$;

the encoded data includes a code block, the code block includes $m$ code sub-blocks, and a size of the code sub-block is $N'$, where $N'=2^n$;

the allocation sequence includes $S$-1 variables $\{A_0,A_1,A_2,...,A_{S-2}\}$; and a relationship between elements in the allocation sequence is $A_0 \le A_1 \le ... \le A_{S-2}$.

Optionally, a length of each to-be-encoded sub-block is:

$$E_0 = E-(m-1)\times N', \text{ or } E_i = N', \text{ where } i\in\{1,2,...,m-2,m-1\}.$$

Optionally, that the processing unit 902 is configured to determine a quantity of information bits in each to-be-encoded sub-block in the to-be-encoded block based on the length of the to-be-encoded block and an allocation sequence may specifically include:

when $i$=0, determining that a quantity of information bits in a 0th to-be-encoded sub-block is $J_0=\frac{A_0\times E_0}{N'}-\Delta_0$, where $A_0$ is a 0th element in the allocation sequence, and $\Delta_0$ is determined based on a difference between $E_0$ and $N'$, whose value is 0 or 1;

when $i$=1, determining that a quantity of information bits in a 1st to-be-encoded sub-block is $J_1=A_1-\Delta_1$, where $A_1$ is a 1st element in the allocation sequence, and $\Delta_1$ is determined based on a difference between $E_0$ and $N'$, whose value is 0 or 1;

when $i \in \{2,3,...,m-2\}$, determining that a quantity of information bits in an $i$th to-be-encoded sub-block is $J_i=A_i$, where $A_i$ is an $i$th element in the allocation sequence; or

when $i=m$-1, determining that a quantity of information bits in an ($m$-1)th to-be-encoded sub-block is $J_{m-1}=K-\sum_{i=0}^{m-2} J_i$.

Optionally, a length of each to-be-encoded sub-block is:

$$E_{m-2} = E-(m-1)\times N', \text{ or } E_i = N', \text{ where } i\in\{0,1,2,...,m-3,m-1\}.$$

Optionally, that the processing unit 902 is configured to determine a quantity of information bits in each to-be-encoded sub-block in the to-be-encoded block based on the length of the to-be-encoded block and an allocation sequence may specifically include:

when $i \in \{2,3,...,m-3\}$, determining that a quantity of information bits in an $i^{th}$ to-be-encoded sub-block is $J_i=A_i$, where $A_i$ is an $i^{th}$ element in the allocation sequence;

when $i=m-2$, determining that a quantity of information bits in an $(m-2)^{th}$ to-be-encoded sub-block is $J_{m-2}=\frac{A_{m-2}\times E_{m-2}}{N'}-\Delta_2$, where $A_{m-2}$ is an $(m-2)^{th}$ element in the allocation sequence, and $\Delta_2$ is determined based on a difference between $E_{m-2}$ and $N'$, whose value is 0 or 1; or

when $i=m-1$, determining that a quantity of information bits in an $(m-1)^{th}$ to-be-encoded sub-block is $J_{m-1}=K-\sum_{i=0}^{m-2}J_i$.

Optionally, that the processing unit 902 is configured to encode the to-be-encoded block to obtain encoded data may specifically include:

dividing the $K$ information bits into $m$ segments based on information bit data of each to-be-encoded sub-block;

determining an information bit and a frozen bit of each code sub-block, and constructing an information sequence with a size of $m\times 2^n$ based on the quantity $m$ of code sub-blocks; and

inserting the $K$ information bits into a to-be-encoded sequence based on locations of information bits in the information sequence, and performing modulo two multiplication on the to-be-encoded sequence and an encoding matrix to obtain the encoded data.

Optionally, the encoding matrix is $G=\begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$,

$G$ is a matrix with a size of $(m\times 2^n)\times(m\times 2^n)$, $m$ and $n$ are positive integers,

the matrix $G_{N'}$ is a polar generator matrix with a size of $2^n\times 2^n$, and

the matrix $O$ is an all-zero matrix with a size of $2^n\times 2^n$.

Optionally, when sending the encoded data (the encoded data is obtained based on the encoding matrix $G$), the communication unit 901 is configured to first send an $(m-1)^{th}$ to-be-encoded sub-block, and then successively send an $i^{th}$ code sub-block, where $i$ satisfies $0\le i\le m-2$.

Optionally, the encoding matrix is $G'=\begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}$, $G'$ is a matrix with a size of $(m\times 2^n)\times(m\times 2^n)$, $m$ and $n$ are positive integers,

the matrix $G_{N'}$ is a polar generator matrix with a size of $2^n\times 2^n$, and

the matrix $O$ is an all-zero matrix with a size of $2^n\times 2^n$.

Optionally, when sending the encoded data (the encoded data is obtained based on the encoding matrix $G'$), the communication unit 901 is configured to successively send an $i^{th}$ code sub-block, where $i$ satisfies $0\le i\le m-1$.

For specific execution procedures of the communication unit 901 and the processing unit 902 in this implementation, refer to the descriptions in the method embodiments corresponding to FIG. 3 to FIG. 7. Details are not described herein again. In the data processing method implemented by the communication apparatus, an information bit construction and encoding method based on the allocation sequence is designed. The information bit construction method is simple and effective, and helps improve system performance and reduce system power consumption. In addition, information bit construction and rate matching when a length of a code sub-block is less than an integer multiple of $2^n$ can

be supported in the method.

In another possible implementation, the communication unit 901 is configured to receive encoded data, and the processing unit 902 is configured to decode the encoded data to obtain decoded data. The encoded data is obtained by encoding a to-be-encoded block. The to-be-encoded block includes a plurality of to-be-encoded sub-blocks. A quantity of information bits in each to-be-encoded sub-block in the to-be-encoded block is determined based on a length of the to-be-encoded block and an allocation sequence. The allocation sequence is used to describe quantities of information bits in all to-be-encoded sub-blocks except a last to-be-encoded sub-block in the to-be-encoded block in a case of a same code rate and a same to-be-encoded sub-block size.

Optionally, the length of the to-be-encoded block is $E = K/R$, where $R$ is a code rate;

the to-be-encoded block includes $m$ to-be-encoded sub-blocks, where $m=\left\lceil \frac{E}{N'} \right\rceil$;

the encoded data includes a code block, the code block includes $m$ code sub-blocks, and a size of the code sub-block is $N'$, where $N'=2^n$;

the allocation sequence includes S-1 variables $\{A_0,A_1,A_2,...,A_{S-2}\}$; and a relationship between elements in the allocation sequence is $A_0 \le A_1 \le ... \le A_{S-2}$.

Optionally, a length of each to-be-encoded sub-block is:

$$E_0 = E-(m-1)\times N', \text{ or } E_i = N', \text{ where } i\in\{1,2,...,m-2,m-1\}.$$

Optionally, when $i$=0, a quantity of information bits in a 0th to-be-encoded sub-block is $J_0 = \frac{A_0 \times E_0}{N'} - \Delta_0$, where $A_0$ is a 0th element in the allocation sequence, and $\Delta_0$ is determined based on a difference between $E_0$ and $N'$, whose value is 0 or 1;

when $i$=1, a quantity of information bits in a 1st to-be-encoded sub-block is $J_1=A_1-\Delta_1$, where $A_1$ is a 1st element in the allocation sequence, and $\Delta_1$ is determined based on a difference between $E_0$ and $N'$, whose value is 0 or 1;

when $i \in \{2,3,...,m-2\}$, a quantity of information bits in an $i$th to-be-encoded sub-block is $J_i=A_i$, where $A_i$ is an $i$th element in the allocation sequence; or

when $i=m-1$, a quantity of information bits in an $(m-1)$th to-be-encoded sub-block is $J_{m-1} = K - \sum_{i=0}^{m-2} J_i$.

Optionally, a length of each to-be-encoded sub-block is:

$$E_{m-2} = E-(m-1)\times N', \text{ or } E_i = N', \text{ where } i\in\{0,1,2,...,m-3,m-1\}.$$

Optionally, when $i \in \{2,3,...,m-3\}$, a quantity of information bits in an $i$th to-be-encoded sub-block is $J_i=A_i$, where $A_i$ is an $i$th element in the allocation sequence; or

when $i=m-2$, a quantity of information bits in an $(m-2)$th to-be-encoded sub-block is $J_{m-2} = \frac{A_{m-2} \times E_{m-2}}{N'} - \Delta_2$, where $A_{m-2}$ is an $(m-2)$th element in the allocation sequence, and $\Delta_2$ is determined based on a difference between $E_{m-2}$ and $N'$, whose value is 0 or 1; or

when $i=m-1$, a quantity of information bits in an $(m-1)$th to-be-encoded sub-block is $J_{m-1} = K - \sum_{i=0}^{m-2} J_i$.

Optionally, the encoded data is obtained by performing encoding by using an encoding matrix $G$, where the

encoding matrix

$$G=\begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$$

, $G$ is a matrix with a size of $(m\times 2^n)\times(m\times 2^n)$, $m$ and $n$ are positive integers, the matrix $G_{N'}$ is a polar generator matrix with a size of $2^n\times 2^n$, and the matrix $O$ is an all-zero matrix with a size of $2^n\times 2^n$.

Optionally, that the processing unit 902 is configured to decode the encoded data to obtain decoded data may specifically include:

obtaining marked data corresponding to a 0th receiving sub-block and marked data corresponding to a 1st receiving sub-block, where the 0th receiving sub-block is an $(m\text{-}1)$th code sub-block, and the 1st receiving sub-block is a 0th code sub-block;
performing an F operation on the marked data corresponding to the 0th receiving sub-block and the marked data corresponding to the 1st receiving sub-block, to obtain marked data corresponding to the 1st receiving sub-block after the F operation;
performing polar code decoding on the marked data corresponding to the 1st receiving sub-block after the F operation, to obtain decoded data corresponding to the 1st receiving sub-block; and
enhancing, based on the marked data corresponding to the 1st receiving sub-block and the decoded data corresponding to the 1st receiving sub-block, the marked data corresponding to the 0th receiving sub-block.

Optionally, the processing unit 902 is further configured to:

obtain marked data corresponding to a $q$th receiving sub-block, where $q$ is $2 \le q \le m\text{-}1$, and the $q$th receiving sub-block is a $(q\text{-}1)$th code sub-block;
perform an F operation on the marked data corresponding to the $q$th receiving sub-block and enhanced marked data corresponding to the 0th receiving sub-block, to obtain marked data corresponding to the $q$th receiving sub-block after the F operation;
perform polar code decoding on the marked data corresponding to the $q$th receiving sub-block after the F operation, to obtain decoded data corresponding to the $q$th receiving sub-block; and
enhance, based on the marked data corresponding to the $q$th receiving sub-block and the decoded data corresponding to the $q$th receiving sub-block, the enhanced marked data corresponding to the 0th receiving sub-block.

Optionally, the encoded data is obtained by performing encoding by using an encoding matrix $G'$, where the encoding matrix

$$G'=\begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}$$

, G' is a matrix with a size of $(m\times 2^n)\times(m\times 2^n)$, $m$ and $n$ are positive integers, the matrix $G_{N'}$ is a polar generator matrix with a size of $2^n \times 2^n$, and the matrix $O$ is an all-zero matrix with a size of $2^n \times 2^n$.

Optionally, that the processing unit 902 is configured to decode the encoded data to obtain decoded data may specifically include:

obtain marked data corresponding to a 0th receiving sub-block and marked data corresponding to a 1st receiving sub-block, where the 0th receiving sub-block is a 0th code sub-block, and the 1st receiving sub-block is a 1st code sub-block;
perform an F operation on the marked data corresponding to the 0th receiving sub-block and the marked data corresponding to the 1st receiving sub-block, to obtain marked data corresponding to the 0th receiving sub-block after the F operation;
perform polar code decoding on the marked data corresponding to the 0th receiving sub-block after the F operation, to obtain decoded data corresponding to the 0th receiving sub-block; and
enhance, based on the marked data corresponding to the 0th receiving sub-block and the decoded data corresponding to the 0th receiving sub-block, the marked data corresponding to the 1st receiving sub-block.

Optionally, the processing unit 902 is further configured to:

obtain marked data corresponding to a $p^{th}$ receiving sub-block, where $p$ is $2 \leq p \leq m-1$, and the $p^{th}$ receiving sub-block is a $p^{th}$ code sub-block;

perform an F operation on the marked data corresponding to the $p^{th}$ receiving sub-block and enhanced marked data corresponding to a $(p-1)^{th}$ receiving sub-block, to obtain marked data corresponding to the $(p-1)^{th}$ receiving sub-block after the F operation;

perform polar code decoding on the marked data corresponding to the $(p-1)^{th}$ receiving sub-block after the F operation, to obtain decoded data corresponding to the $(p-1)^{th}$ receiving sub-block; and

enhance, based on the enhanced marked data corresponding to the $(p-1)^{th}$ receiving sub-block and the decoded data corresponding to the $(p-1)^{th}$ receiving sub-block, the marked data corresponding to the $p^{th}$ receiving sub-block.

For specific execution procedures of the communication unit 901 and the processing unit 902 in this implementation, refer to the descriptions in the method embodiments corresponding to FIG. 3 to FIG. 7. Details are not described herein again. **In** the data processing method implemented by the communication apparatus, it is designed that the encoded data includes a plurality of code blocks, and quantities of information bits in the plurality of code blocks are designed according to a specific rule. **In** this case, stream decoding can be implemented for the encoded data.

The following describes a device including a plurality of functional units shown in FIG. 9. The device in this application includes the plurality of functional units shown in FIG. 9. FIG. 10 is a diagram of a communication device according to this application. The communication device is configured to implement the data processing methods in the foregoing method embodiments. The communication device 1000 may alternatively be a chip system. It may be understood that the communication device 1000 may be, for example, a terminal device, or may be a network device.

The communication device 1000 includes a communication interface 1001 and a processor 1002. The communication interface 1001 may be, for example, a transceiver, an interface, a bus, a circuit, or an apparatus that can implement a receiving function and a sending function. The communication interface 1001 is configured to communicate with another device through a transmission medium, so that the device 1000 may communicate with the another device. The processor 1002 is configured to perform a processing-related operation.

In a possible implementation, the communication interface 1001 is configured to obtain K information bits, and the processor 1002 is configured to determine a length of a to-be-encoded block based on K, and determine a quantity of information bits in each to-be-encoded sub-block in the to-be-encoded block based on the length of the to-be-encoded block and an allocation sequence. The allocation sequence is used to describe quantities of information bits in all to-be-encoded sub-blocks except a last to-be-encoded sub-block in the to-be-encoded block in a case of a same code rate and a same to-be-encoded sub-block size. The processor 1002 is configured to encode the to-be-encoded block to obtain encoded data, and the communication interface 1001 is configured to send the encoded data.

For specific execution procedures of the communication interface 1001 and the processor 1002 in this implementation, refer to the first aspect and the descriptions in the method embodiments corresponding to FIG. 3 to FIG. 7, or refer to the descriptions of the communication unit 901 and the processing unit 902 in FIG. 9. Details are not described herein again. In the data processing method implemented by the communication device, an information bit construction and encoding method based on the allocation sequence is designed. The information bit construction method is simple and effective, and helps improve system performance and reduce system power consumption. In addition, information bit construction and rate matching when a length of a code sub-block is less than an integer multiple of $2^n$ can be supported in the method.

In another possible implementation, the communication interface 1001 is configured to receive encoded data, and the processor 1002 is configured to decode the encoded data to obtain decoded data. The encoded data is obtained by encoding a to-be-encoded block. The to-be-encoded block includes a plurality of to-be-encoded sub-blocks. A quantity of information bits in each to-be-encoded sub-block in the to-be-encoded block is determined based on a length of the to-be-encoded block and an allocation sequence. The allocation sequence is used to describe quantities of information bits in all to-be-encoded sub-blocks except a last to-be-encoded sub-block in the to-be-encoded block in a case of a same code rate and a same to-be-encoded sub-block size.

For specific execution procedures of the communication interface 1001 and the processor 1002 in this implementation, refer to the second aspect and the descriptions in the method embodiments corresponding to FIG. 3 to FIG. 7, or refer to the descriptions of the communication unit 901 and the processing unit 902 in FIG. 9. Details are not described herein again. The encoded data in the data processing method implemented by the communication device includes a plurality of code blocks, and quantities of information bits in the plurality of code blocks are designed according to a specific rule. In this case, stream decoding can be implemented for the encoded data.

Optionally, the communication device 1000 may further include at least one memory 1003, configured to store program instructions and/or data. In an implementation, the memory is coupled to the processor. The coupling in this application may be an indirect coupling or a communication connection between apparatuses, units, or modules in an electrical form, a mechanical form, or another form, and is used for information exchange between the apparatuses, the units, or the modules. The processor may perform an operation in collaboration with the memory. The processor may execute the program instructions stored in the memory. The at least one memory and the processor are integrated together.

In this application, a specific connection medium between the communication interface, the processor, and the memory is not limited. For example, the memory, the processor, and the communication interface are connected through a bus. The bus 1004 is represented by a thick line in FIG. 10. A manner of a connection between other components is merely an example for description, and is not construed as a limitation. The bus may be classified into an address bus, a data bus, a control bus, and the like. For ease of representation, only one thick line is for representing the bus in FIG. 10, but this does not mean that there is only one bus or only one type of bus.

In this application, the processor may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in this application. The general-purpose processor may be a microprocessor, any conventional processor, or the like. The steps of the methods disclosed with reference to this application may be directly implemented by a hardware processor, or may be implemented by a combination of hardware and a software module in a processor.

In this application, the memory may be a non-volatile memory, for example, a hard disk drive (hard disk drive, HDD) or a solid-state drive (solid-state drive, SSD), or may be a volatile memory (volatile memory), for example, a random access memory (random access memory, RAM). The memory is any other medium that can carry or store expected program code in a form of an instruction structure or a data structure and that can be accessed by a computer, but is not limited thereto. Alternatively, the memory in this application may be a circuit or any other apparatus that can implement a storage function, and is configured to store program instructions and/or data.

This application provides a communication apparatus. The communication apparatus includes an input/output interface and a logic circuit. The input/output interface is configured to input or output data. The logic circuit processes the data according to the methods in the embodiments corresponding to FIG. 3 to FIG. 7, to obtain processed data.

This application provides a communication apparatus. The communication apparatus includes an input/output interface and a logic circuit. The input/output interface is configured to input or output data. The logic circuit processes the data according to the methods in the embodiments corresponding to FIG. 3 to FIG. 7, to obtain processed data.

This application provides a communication system. The communication system includes the terminal device and the network device in the embodiments corresponding to FIG. 3 to FIG. 7.

This application provides a computer-readable storage medium. The computer-readable storage medium stores a program or instructions. When the program or the instructions are run on a computer, the computer is enabled to perform the data processing methods in the embodiments corresponding to FIG. 3 to FIG. 7.

This application provides a computer program product. The computer program product includes instructions. When the instructions are run on a computer, the computer is enabled to perform the data processing methods in the embodiments corresponding to FIG. 3 to FIG. 7.

This application provides a chip or a chip system. The chip or the chip system includes at least one processor and an interface. The interface and the at least one processor are interconnected through a line. The at least one processor is configured to run a computer program or instructions, to perform the data processing methods in the embodiments corresponding to FIG. 3 to FIG. 7.

The interface in the chip may be an input/output interface, a pin, a circuit, or the like.

The chip system may be a system on chip (system on chip, SoC), or may be a baseband chip, or the like. The baseband chip may include a processor, a channel encoder, a digital signal processor, a modem, an interface module, and the like.

**In** an implementation, the chip or the chip system described above in this application further includes at least one memory, and the at least one memory stores instructions. The memory may be a storage unit inside the chip, for example, a register or a buffer, or may be a storage unit (for example, a read-only memory or a random access memory) of the chip.

All or some of the technical solutions provided in this application may be implemented by using software, hardware, firmware, or any combination thereof. When software is used to implement embodiments, all or some of embodiments may be implemented in a form of a computer program product. The computer program product includes one or more computer instructions. When the computer program instructions are loaded and executed on a computer, the procedure or functions according to this application are all or partially generated. The computer may be a general-purpose computer, a dedicated computer, a computer network, a network device, a terminal device, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible to the computer, or a data storage device, for example, a server or a data center, integrating one or more usable media. The usable medium may be a magnetic medium (for example, a floppy disk, a hard disk, or a magnetic tape), an optical medium (for example, a digital video disc (digital video disc, DVD)), a semiconductor medium, or the like.

In this application, on the premise that there is no logical conflict, embodiments may be mutually referenced. For example, methods and/or terms in the method embodiments may be mutually referenced. For example, functions and/or terms in the apparatus embodiments may be mutually referenced. For example, functions and/or terms in the apparatus embodiments and the method embodiments may be mutually referenced.

It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

**1.** A data processing method, comprising:

obtaining K information bits;
determining a length of a to-be-encoded block based on *K;*
determining a quantity of information bits in each to-be-encoded sub-block in the to-be-encoded block based on the length of the to-be-encoded block and an allocation sequence, wherein
the allocation sequence is used to describe quantities of information bits in all to-be-encoded sub-blocks except a last to-be-encoded sub-block in the to-be-encoded block in a case of a same code rate and a same to-be-encoded sub-block size;
encoding the to-be-encoded block to obtain encoded data; and
sending the encoded data.

**2.** The method according to claim **1,** wherein

the length of the to-be-encoded block is $E = K/R$, wherein R is a code rate;
the to-be-encoded block comprises *m* to-be-encoded sub-blocks, wherein $m = \left\lceil \frac{E}{N'} \right\rceil$;
the encoded data comprises a code block, the code block comprises *m* code sub-blocks, and a size of the code sub-block is $N'$, wherein $N' = 2^n$;
the allocation sequence comprises $S$-1 variables $\{A_0, A_1, A_2, ..., A_{S-2}\}$; and
a relationship between elements in the allocation sequence is $A_0 \le A_1 \le ... \le A_{S-2}$.

**3.** The method according to claim 1 or 2, wherein a length of each to-be-encoded sub-block is:

$$E_0 = E - (m-1) \times N',$$

or

$$E_i = N',$$

**wherein** $i \in \{1,2,...,m-2,m-1\}$.

**4.** The method according to claim 3, wherein the determining a quantity of information bits in each to-be-encoded sub-block in the to-be-encoded block based on the length of the to-be-encoded block and an allocation sequence comprises:

when $i = 0$, determining that a quantity of information bits in a $0^{th}$ to-be-encoded sub-block is $J_0 = \frac{A_0 \times E_0}{N'} - \Delta_0$, wherein $A_0$ is a $0^{th}$ element in the allocation sequence, and $\Delta_0$ is determined based on a difference between $E_0$ and N', whose value is 0 or 1;

when $i=1$, determining that a quantity of information bits in a 1st to-be-encoded sub-block is $J_1 = A_1 - \Delta_1$, wherein $A_1$ is a 1st element in the allocation sequence, and $\Delta_1$ is determined based on a difference between $E_0$ and N', whose value is 0 or 1;
when $i \in \{2,3,...,m-2\}$, determining that a quantity of information bits in an $i^{th}$ to-be-encoded sub-block is $J_i = A_i$, wherein $A_i$ is an $i^{th}$ element in the allocation sequence; or
when $i = m-1$, determining that a quantity of information bits in an $(m-1)^{th}$ to-be-encoded sub-block is

$$J_{m-1} = K - \sum_{i=0}^{m-2} J_i$$

.

**5.** The method according to claim 1 or 2, wherein a length of each to-be-encoded sub-block is:

$$E_{m-2} = E - (m-1) \times N',$$

or

$$E_i = N',$$

**wherein** $i \in \{0,1,2,...,m-3,m-1\}$.

**6.** The method according to claim 5, wherein the determining a quantity of information bits in each to-be-encoded sub-block in the to-be-encoded block based on the length of the to-be-encoded block and an allocation sequence comprises:

when $i \in \{2, 3,..., m-3\}$, determining that a quantity of information bits in an $i^{th}$ to-be-encoded sub-block is $J_i = A_i$, wherein $A_i$ is an $i^{th}$ element in the allocation sequence;
when $i = m - 2$, determining that a quantity of information bits in an $(m-2)^{th}$ to-be-encoded sub-block is

$$J_{m-2} = \frac{A_{m-2} \times E_{m-2}}{N'} - \Delta_2$$

, wherein $A_{m-2}$ is an $(m-2)^{th}$ element in the allocation sequence, and $\Delta_2$ is determined based on a difference between $E_{m-2}$ and N', whose value is 0 or 1; or
when $i = m-1$, determining that a quantity of information bits in an $(m-1)^{th}$ to-be-encoded sub-block is

$$J_{m-1} = K - \sum_{i=0}^{m-2} J_i$$

.

**7.** The method according to any one of claims 1 to 6, wherein the encoding the to-be-encoded block to obtain encoded data comprises:

dividing the $K$ information bits into $m$ segments based on information bit data of each to-be-encoded sub-block;
determining an information bit and a frozen bit of each code sub-block, and constructing an information sequence with a size of $m \times 2^n$ based on the quantity $m$ of code sub-blocks; and
inserting the K information bits into a to-be-encoded sequence based on locations of information bits in the information sequence, and performing modulo two multiplication on the to-be-encoded sequence and an encoding matrix to obtain the encoded data.

**8.** The method according to claim 7, wherein the encoding matrix is

$$G = \begin{bmatrix} G_{N'} & O & \cdots & O \\ O & G_{N'} & \cdots & O \\ \cdots & \cdots & \ddots & \cdots \\ G_{N'} & G_{N'} & \cdots & G_{N'} \end{bmatrix}$$

, G is a matrix with a size of $(m \times 2^n) \times (m \times 2^n)$, $m$ and $n$ are positive integers,

the matrix $G_{N'}$ is a polar generator matrix with a size of $2^n \times 2^n$, and

the matrix $O$ is an all-zero matrix with a size of $2^n \times 2^n$.

**9.** The method according to claim 8, wherein the sending the encoded data comprises:

sending an ($m$-1)$^{th}$ to-be-encoded sub-block; and
successively sending an $i^{th}$ code sub-block, wherein $i$ satisfies $0 \le i \le m-2$.

**10.** The method according to claim 7, wherein the encoding matrix is

$$G'=\begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}$$

, G' is a matrix with a size of $(m\times 2^n)\times(m\times 2^n)$, $m$ and $n$ are positive integers,

the matrix $G_{N'}$ is a polar generator matrix with a size of $2^n \times 2^n$, and
the matrix $O$ is an all-zero matrix with a size of 2" $\times$ $2^n$.

**11.** The method according to claim 10, wherein the sending the encoded data comprises: successively sending an $i^{th}$ code sub-block, wherein $i$ satisfies $0 \le i \le m-1$.

**12.** A data processing method, comprising:

receiving encoded data, wherein the encoded data is obtained by encoding a to-be-encoded block,
the to-be-encoded block comprises a plurality of to-be-encoded sub-blocks, a quantity of information bits in each to-be-encoded sub-block in the to-be-encoded block is determined based on a length of the to-be-encoded block and an allocation sequence, and
the allocation sequence is used to describe quantities of information bits in all to-be-encoded sub-blocks except a last to-be-encoded sub-block in the to-be-encoded block in a case of a same code rate and a same to-be-encoded sub-block size; and
decoding the encoded data to obtain decoded data.

**13.** The method according to claim 12, wherein

the length of the to-be-encoded block is $E = K/R$, wherein R is a code rate;
the to-be-encoded block comprises $m$ to-be-encoded sub-blocks, wherein $m=\left\lceil \frac{E}{N'} \right\rceil$;
the encoded data comprises a code block, the code block comprises $m$ code sub-blocks, and a size of the code sub-block is $N'$, wherein $N' = 2^n$;
the allocation sequence comprises S-1 variables $\{A_0,A_1,A_2,...,A_{S-2}\}$; and
a relationship between elements in the allocation sequence is $A_0 \le A_1 \le ... \le A_{S-2}$.

**14.** The method according to claim 12 or 13, wherein a length of each to-be-encoded sub-block is:

$$E_0 = E-(m-1)\times N',$$

or

$$E_i = N',$$

**wherein** $i \in \{1,2,...,m-2,m-1\}$.

**15.** The method according to claim 14, wherein

when $i = 0$ , a quantity of information bits in a $0^{th}$ to-be-encoded sub-block is $J_0 = \frac{A_0 \times E_0}{N'} - \Delta_0$ , wherein $A_0$ is a $0^{th}$ element in the allocation sequence, and $\Delta_0$ is determined based on a difference between $E_0$ and N', whose value is 0 or 1;

when $i = 1$, a quantity of information bits in a $1^{st}$ to-be-encoded sub-block is $J_1 = A_1 - \Delta_1$, wherein $A_1$ is a $1^{st}$ element in the allocation sequence, and $\Delta_1$ is determined based on a difference between $E_0$ and N', whose value is 0 or 1;

when $i \in \{2, 3,..., m\text{-}2\}$, a quantity of information bits in an $i^{th}$ to-be-encoded sub-block is $J, = A_i$, wherein 4 is an $i^{th}$ element in the allocation sequence; or

when $i = m\text{ -}1,$ a quantity of information bits in an $(m\text{-}1)^{th}$ to-be-encoded sub-block is $J_{m-1} = K - \sum_{i=0}^{m-2} J_i$ .

**16.** The method according to claim 12 or 13, wherein a length of each to-be-encoded sub-block is:

$$E_{m-2} = E - (m-1) \times N',$$

or

$$E_i = N',$$

**wherein** $i \in \{0,1,2,...,m\text{-}3,m\text{-}1\}$.

**17.** The method according to claim 16, wherein

when $i \in \{2,3,...,m\text{-}3\}$, a quantity of information bits in an $i^{th}$ to-be-encoded sub-block is $J_i = A_i$, wherein 4 is an $i^{th}$ element in the allocation sequence; or

when $i = m\text{-}2,$ a quantity of information bits in an $(m\text{-}2)^{th}$ to-be-encoded sub-block is $J_{m-2} = \frac{A_{m-2} \times E_{m-2}}{N'} - \Delta_2$ , wherein $A_{m-2}$ is an $(m\text{-}2)^{th}$ element in the allocation sequence, and $\Delta_2$ is determined based on a difference between $E_{m-2}$ and N', whose value is 0 or 1; or

when $i = m\text{ -}1,$ a quantity of information bits in an $(m\text{-}1)^{th}$ to-be-encoded sub-block is $J_{m-1} = K - \sum_{i=0}^{m-2} J_i$ .

**18.** The method according to any one of claims 12 to 17, wherein the encoded data is obtained by performing encoding by using an encoding matrix G, wherein the encoding matrix $G = \begin{bmatrix} G_{N'} & O & \dots & O \\ O & G_{N'} & \dots & O \\ \dots & \dots & \ddots & \dots \\ G_{N'} & G_{N'} & \dots & G_{N'} \end{bmatrix}$ , $G$ is a matrix with a size of $(m \times 2^n) \times (m \times 2^n)$, $m$ and $n$ are positive integers,

the matrix $G_{N'}$ is a polar generator matrix with a size of $2^n \times 2^n$, and
the matrix $O$ is an all-zero matrix with a size of 2" $\times$ $2^n$.

**19.** The method according to claim 18, wherein the decoding the encoded data to obtain decoded data comprises:

obtaining marked data corresponding to a $0^{th}$ receiving sub-block and marked data corresponding to a $1^{st}$ receiving sub-block, wherein the $0^{th}$ receiving sub-block is an $(m\text{-}1)^{th}$ code sub-block, and the $1^{st}$ receiving sub-block is a $0^{th}$ code sub-block;

performing an F operation on the marked data corresponding to the $0^{th}$ receiving sub-block and the marked data

corresponding to the 1st receiving sub-block, to obtain marked data corresponding to the 1st receiving sub-block after the F operation;
performing polar code decoding on the marked data corresponding to the 1st receiving sub-block after the F operation, to obtain decoded data corresponding to the 1st receiving sub-block; and
enhancing, based on the marked data corresponding to the 1st receiving sub-block and the decoded data corresponding to the 1st receiving sub-block, the marked data corresponding to the 0th receiving sub-block.

**20.** The method according to claim 19, wherein the method further comprises:

obtaining marked data corresponding to a $q^{th}$ receiving sub-block, wherein $q$ is $2 \le q \le m-1$, and the $q^{th}$ receiving sub-block is a $(q-1)^{th}$ code sub-block;
performing an F operation on the marked data corresponding to the $q^{th}$ receiving sub-block and enhanced marked data corresponding to the 0th receiving sub-block, to obtain marked data corresponding to the $q^{th}$ receiving sub-block after the F operation;
performing polar code decoding on the marked data corresponding to the $q^{th}$ receiving sub-block after the F operation, to obtain decoded data corresponding to the $q^{th}$ receiving sub-block; and
enhancing, based on the marked data corresponding to the $q^{th}$ receiving sub-block and the decoded data corresponding to the $q^{th}$ receiving sub-block, the enhanced marked data corresponding to the 0th receiving sub-block.

**21.** The method according to any one of claims 12 to 15, wherein the encoded data is obtained by performing encoding by using an encoding matrix G' , wherein the encoding matrix

$$G'=\begin{bmatrix} G_{N'} & O & \dots & O \\ G_{N'} & G_{N'} & \dots & O \\ \dots & \dots & \ddots & \dots \\ G_{N'} & G_{N'} & \dots & G_{N'} \end{bmatrix}$$

, G' is a matrix with a size of $(m\times 2^n)\times(m\times 2^n)$, $m$ and $n$ are positive integers,

the matrix $G_{N'}$ is a polar generator matrix with a size of $2^n \times 2^n$, and
the matrix $O$ is an all-zero matrix with a size of $2^n \times 2^n$.

**22.** The method according to claim 21, wherein the decoding the encoded data to obtain decoded data comprises:

obtaining marked data corresponding to a 0th receiving sub-block and marked data corresponding to a 1st receiving sub-block, wherein the 0th receiving sub-block is a 0th code sub-block, and the 1st receiving sub-block is a 1st code sub-block;
performing an F operation on the marked data corresponding to the 0th receiving sub-block and the marked data corresponding to the 1st receiving sub-block, to obtain marked data corresponding to the 0th receiving sub-block after the F operation;
performing polar code decoding on the marked data corresponding to the 0th receiving sub-block after the F operation, to obtain decoded data corresponding to the 0th receiving sub-block; and
enhancing, based on the marked data corresponding to the 0th receiving sub-block and the decoded data corresponding to the 0th receiving sub-block, the marked data corresponding to the 1st receiving sub-block.

**23.** The method according to claim 22, wherein the method further comprises:

obtaining marked data corresponding to a $p^{th}$ receiving sub-block, wherein $p$ is $2 \le p \le m-1$, and the $p^{th}$ receiving sub-block is a $p^{th}$ code sub-block;
performing an F operation on the marked data corresponding to the $p^{th}$ receiving sub-block and enhanced marked data corresponding to a $(p-1)^{th}$ receiving sub-block, to obtain marked data corresponding to the $(p-1)^{th}$ receiving sub-block after the F operation;
performing polar code decoding on the marked data corresponding to the $(p-1)^{th}$ receiving sub-block after the F operation, to obtain decoded data corresponding to the $(p-1)^{th}$ receiving sub-block; and
enhancing, based on the enhanced marked data corresponding to the $(p-1)^{th}$ receiving sub-block and the decoded data corresponding to the $(p-1)^{th}$ receiving sub-block, the marked data corresponding to the $p^{th}$ receiving sub-block.

**24.** A data processing apparatus, comprising a unit or a module configured to perform the method according to any one of claims 1 to 11 or claims 12 to 23.

**25.** A communication device, comprising a memory and a processor, wherein

the memory is configured to store instructions; and
the processor is configured to execute the instructions, so that the method according to any one of claims 1 to 11 or claims 12 to 23 is performed.

**26.** A communication system, comprising:

a transmitting end, configured to perform the method according to any one of claims 1 to 11; and
a receiving end, configured to perform the method according to any one of claims 12 to 23.

**27.** A chip, comprising a processor and an interface, wherein
the processor is configured to read instructions to perform the method according to any one of claims 1 to 11 or 12 to 23.

**28.** A communication apparatus, wherein the communication apparatus comprises an input/output interface and a logic circuit, the input/output interface is configured to input or output data, and the logic circuit processes the data according to the method according to any one of claims 1 to 11, to obtain processed data.

**29.** A communication apparatus, wherein the communication apparatus comprises an input/output interface and a logic circuit, the input/output interface is configured to input or output data, and the logic circuit processes the data according to the method according to any one of claims 12 to 23, to obtain processed data.

**30.** A computer-readable storage medium, comprising a program or instructions, wherein when the program or the instructions are run on a computer, the method according to any one of claims 1 to 11 or 12 to 23 is performed.

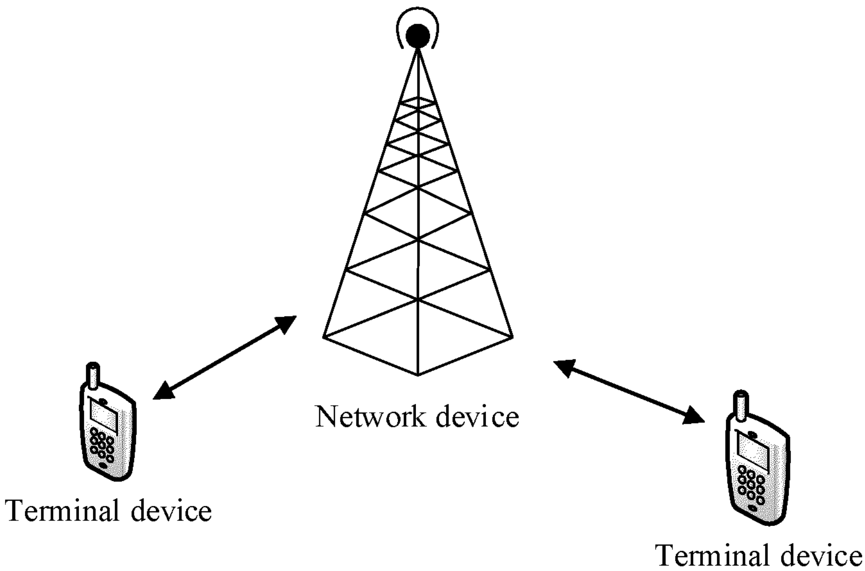
Network device
Terminal device
Terminal device

FIG. 1

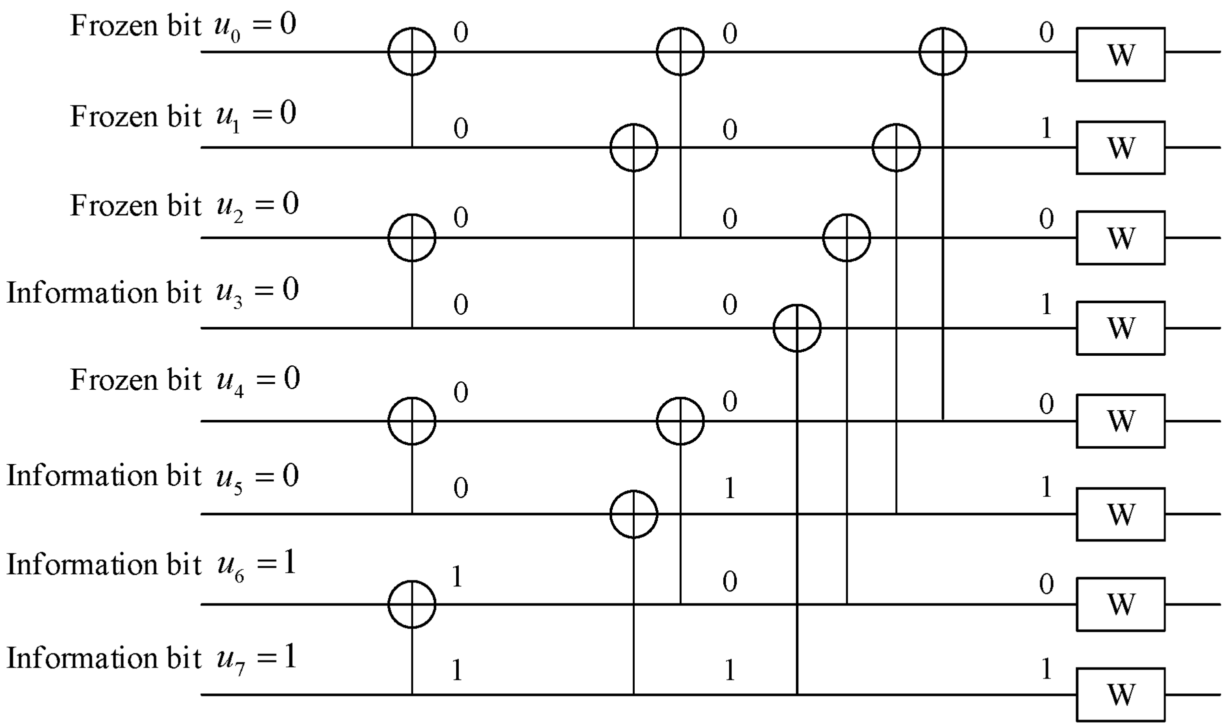
Frozen bit $u_0 = 0$
Frozen bit $u_1 = 0$
Frozen bit $u_2 = 0$
Information bit $u_3 = 0$
Frozen bit $u_4 = 0$
Information bit $u_5 = 0$
Information bit $u_6 = 1$
Information bit $u_7 = 1$
0
0
0
0
0
0
1
1
0
0
0
0
0
1
0
1
0
1
0
1
0
1
0
1
W
W
W
W
W
W
W
W

FIG. 2

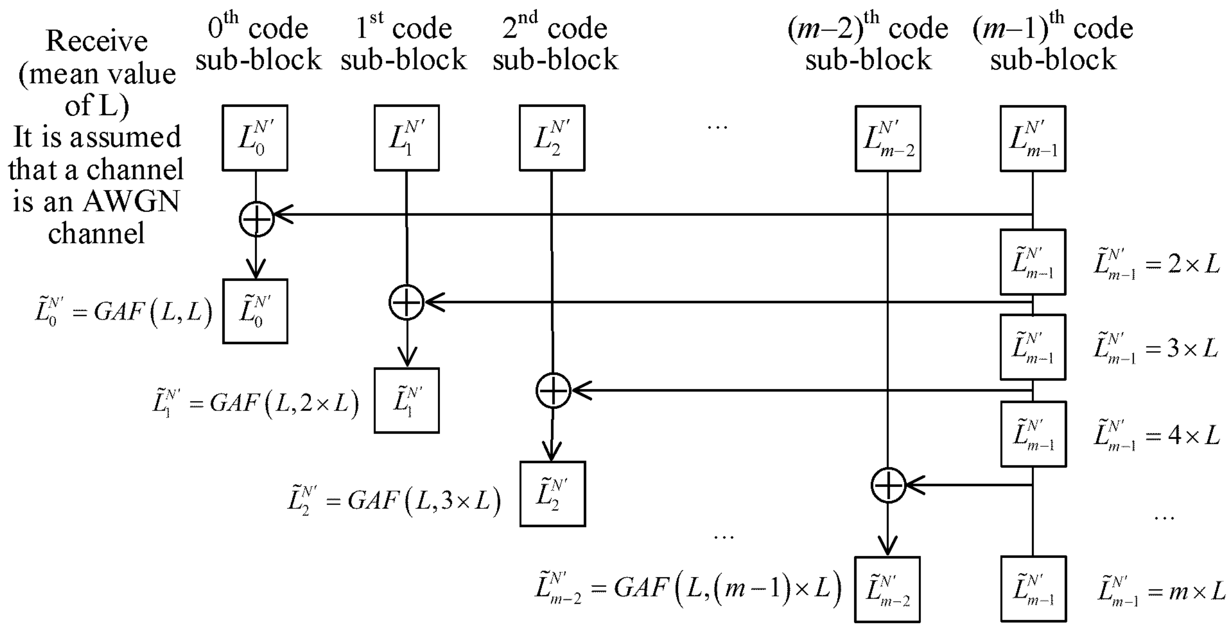
Receive (mean value of L)
It is assumed that a channel is an AWGN channel
0th code sub-block
1st code sub-block
2nd code sub-block
(m–2)th code sub-block
(m–1)th code sub-block
$\tilde{L}_0^{N'} = GAF(L, L)$
$\tilde{L}_1^{N'} = GAF(L, 2\times L)$
$\tilde{L}_2^{N'} = GAF(L, 3\times L)$
$\tilde{L}_{m-2}^{N'} = GAF(L, (m-1)\times L)$
$\tilde{L}_{m-1}^{N'} = 2\times L$
$\tilde{L}_{m-1}^{N'} = 3\times L$
$\tilde{L}_{m-1}^{N'} = 4\times L$
$\tilde{L}_{m-1}^{N'} = m\times L$

FIG. 3

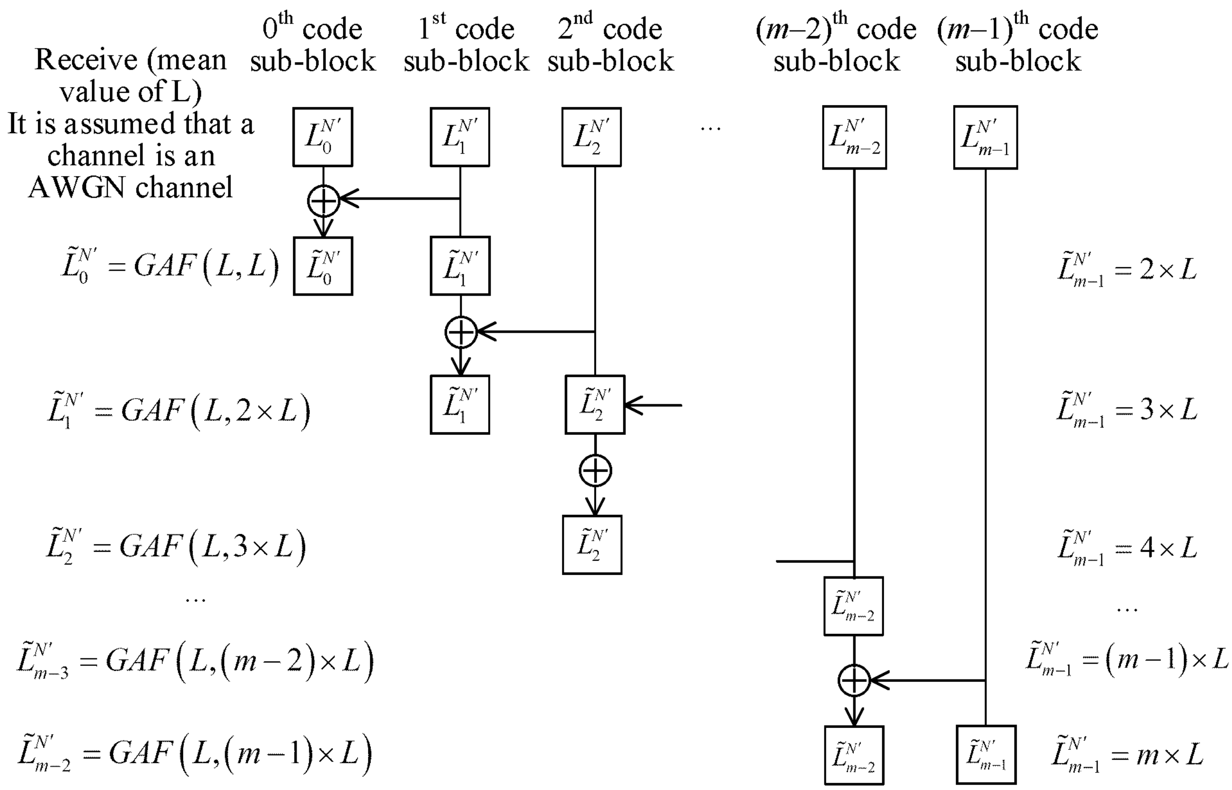
Receive (mean value of L)
It is assumed that a channel is an AWGN channel
0th code sub-block
1st code sub-block
2nd code sub-block
(m–2)th code sub-block
(m–1)th code sub-block
$\tilde{L}_0^{N'} = GAF(L, L)$
$\tilde{L}_1^{N'} = GAF(L, 2\times L)$
$\tilde{L}_2^{N'} = GAF(L, 3\times L)$
$\tilde{L}_{m-3}^{N'} = GAF(L, (m-2)\times L)$
$\tilde{L}_{m-2}^{N'} = GAF(L, (m-1)\times L)$
$\tilde{L}_{m-1}^{N'} = 2\times L$
$\tilde{L}_{m-1}^{N'} = 3\times L$
$\tilde{L}_{m-1}^{N'} = 4\times L$
$\tilde{L}_{m-1}^{N'} = (m-1)\times L$
$\tilde{L}_{m-1}^{N'} = m\times L$

FIG. 4

Quantity of information bits in each code sub-block with a size of $N'$ when $N'$ = 128

| | | | | | | | | | | | | |
|---|---|---|---|---|---|---|---|---|---|---|---|---|
| $K = 32$ | 1 | 31 | | | | | | | | | | |
| $K = 48$ | 1 | 4 | 43 | | | | | | | | | |
| $K = 64$ | 1 | 4 | 5 | 54 | | | | | | | | |
| | 1 | 4 | 5 | 6 | 64 | | | | | | | |
| | 1 | 4 | 5 | 6 | 6 | 74 | | | | | | |
| | 1 | 3 | 5 | 6 | 6 | 7 | 84 | | | | | |
| ⋮ | 1 | 4 | 5 | 6 | 6 | 7 | 9 | 90 | | | | |
| | 1 | 4 | 5 | 6 | 6 | 8 | 9 | 9 | 96 | | | |
| | 1 | 4 | 5 | 6 | 6 | 8 | 9 | 9 | 10 | 102 | | |
| | 1 | 4 | 5 | 6 | 7 | 8 | 9 | 9 | 10 | 10 | 107 | |
| $K = 192$ | 1 | 4 | 5 | 6 | 7 | 9 | 9 | 10 | 10 | 10 | 10 | 111 |

FIG. 5a

Quantity of information bits in each code sub-block with a size of $N'$ when $N' = 256$

| | | | | | | | | | | | | |
|---|---|---|---|---|---|---|---|---|---|---|---|---|
| $K = 64$ | 5 | 59 | | | | | | | | | | |
| $K = 96$ | 4 | 6 | 89 | | | | | | | | | |
| $K = 128$ | 4 | 6 | 11 | 107 | | | | | | | | |
| | 3 | 6 | 10 | 13 | 128 | | | | | | | |
| | 3 | 6 | 9 | 13 | 15 | 146 | | | | | | |
| | 3 | 6 | 10 | 13 | 15 | 16 | 161 | | | | | |
| ⋮ | 3 | 6 | 9 | 13 | 15 | 16 | 18 | 176 | | | | |
| | 3 | 6 | 10 | 13 | 15 | 16 | 18 | 19 | 188 | | | |
| | 3 | 6 | 10 | 13 | 16 | 16 | 18 | 19 | 20 | 199 | | |
| | 3 | 6 | 10 | 13 | 16 | 17 | 19 | 19 | 20 | 21 | 208 | |
| $K = 384$ | 4 | 6 | 10 | 13 | 16 | 17 | 19 | 20 | 21 | 21 | 21 | 215 |

FIG. 5b

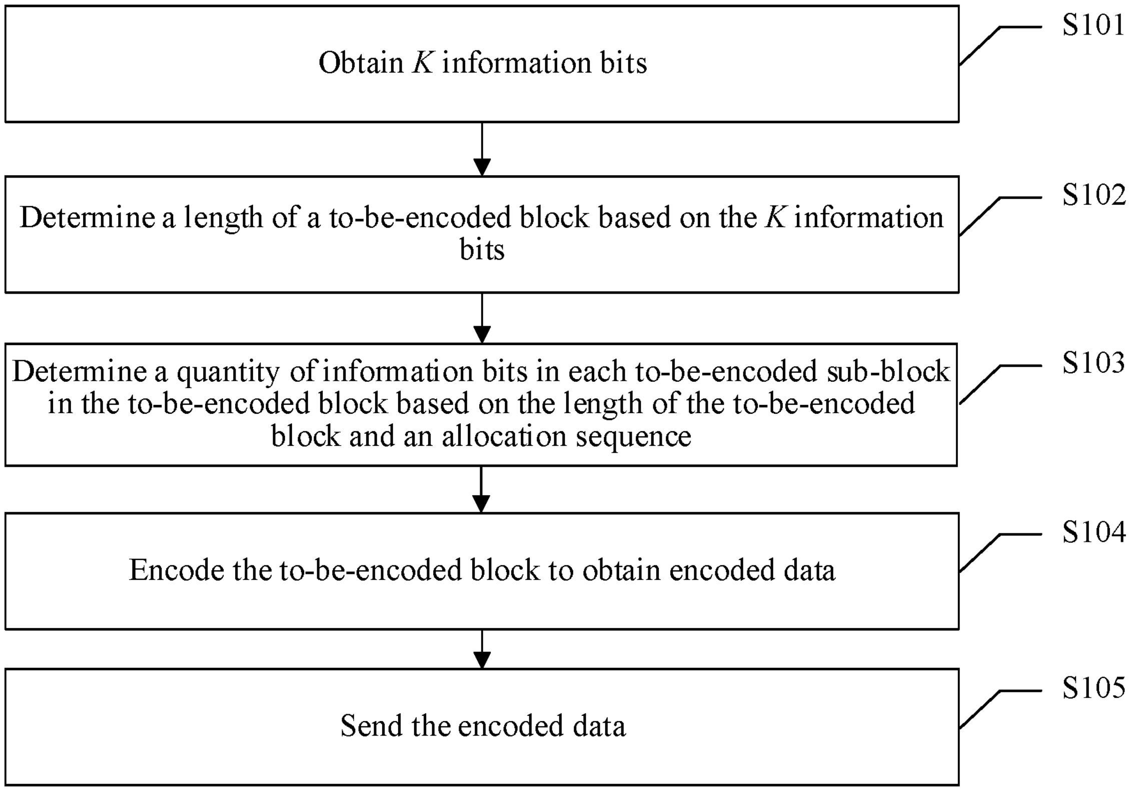
Obtain K information bits
S101
Determine a length of a to-be-encoded block based on the K information bits
S102
Determine a quantity of information bits in each to-be-encoded sub-block in the to-be-encoded block based on the length of the to-be-encoded block and an allocation sequence
S103
Encode the to-be-encoded block to obtain encoded data
S104
Send the encoded data
S105

FIG. 6

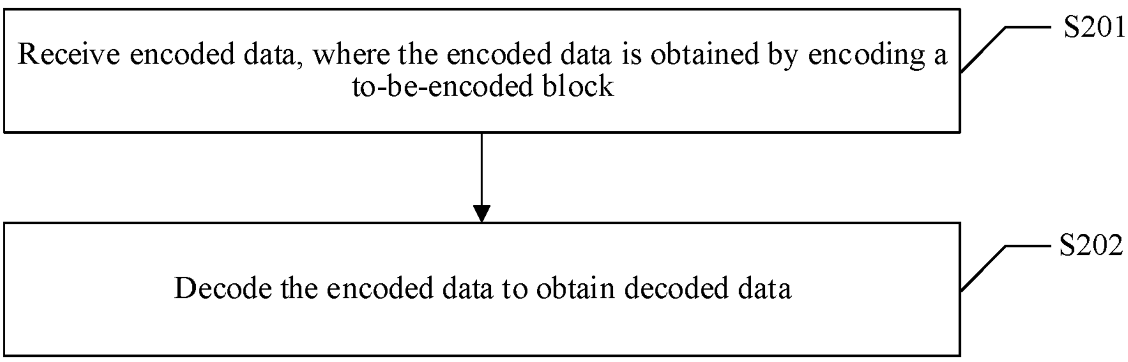
Receive encoded data, where the encoded data is obtained by encoding a to-be-encoded block
S201
Decode the encoded data to obtain decoded data
S202

FIG. 7

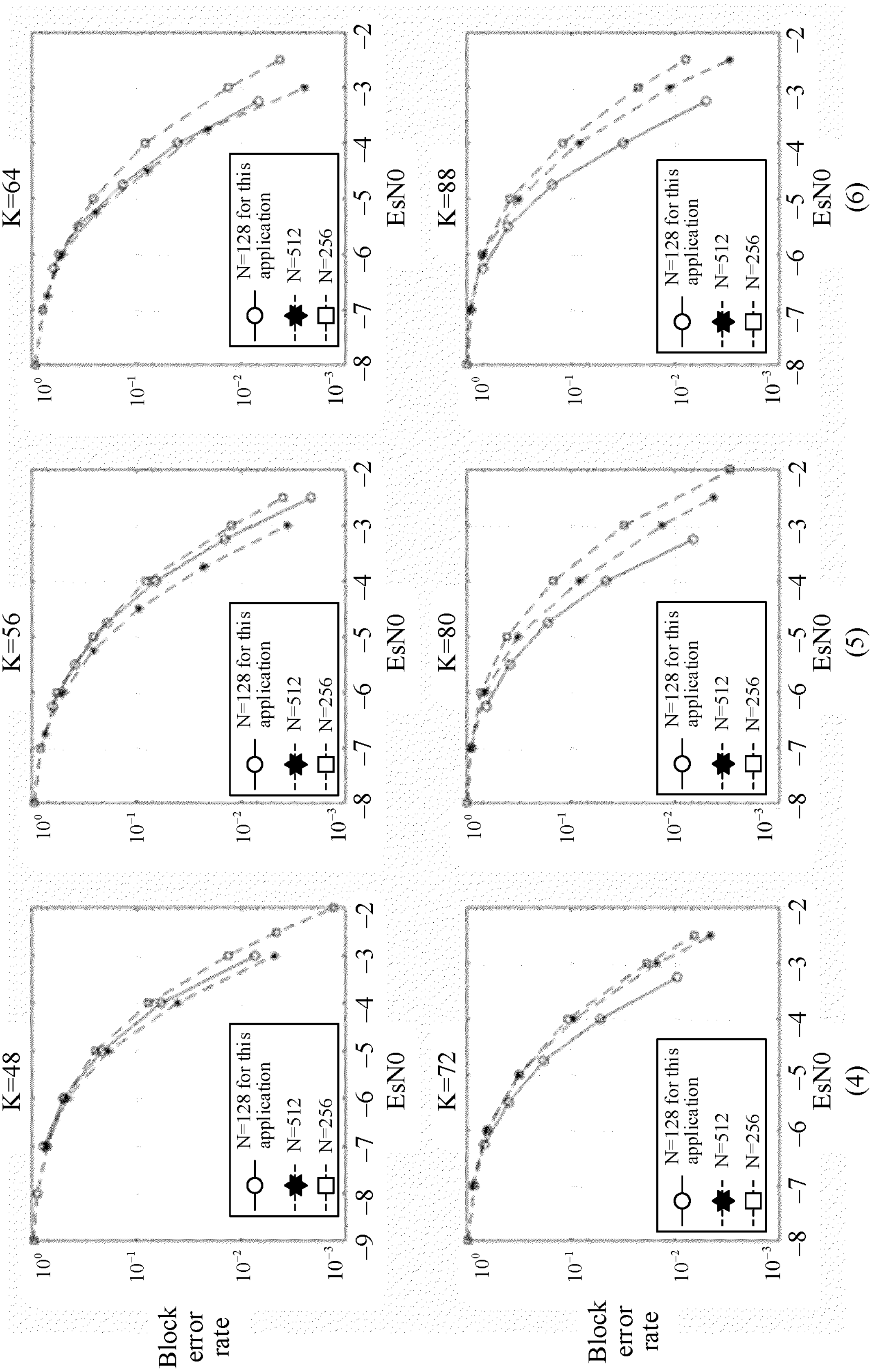
(1)
K=48
(2)
K=56
(3)
K=64
K=72
(4)
K=80
(5)
K=88
(6)
Block error rate
EsN0
N=128 for this application
N=512
N=256

FIG. 8

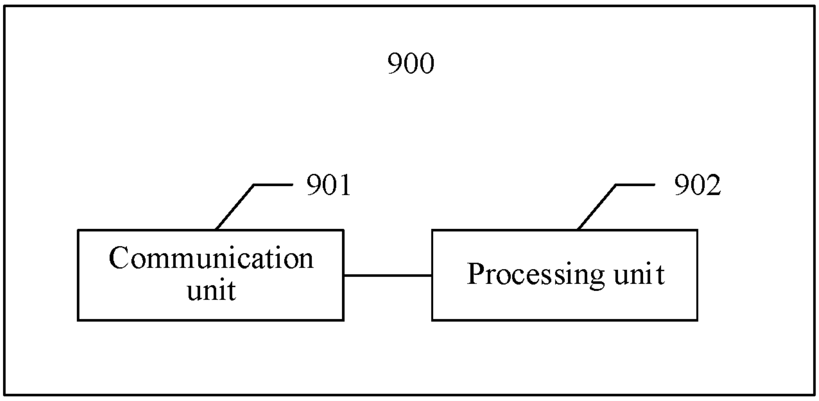
900
901
902
Communication unit
Processing unit

FIG. 9

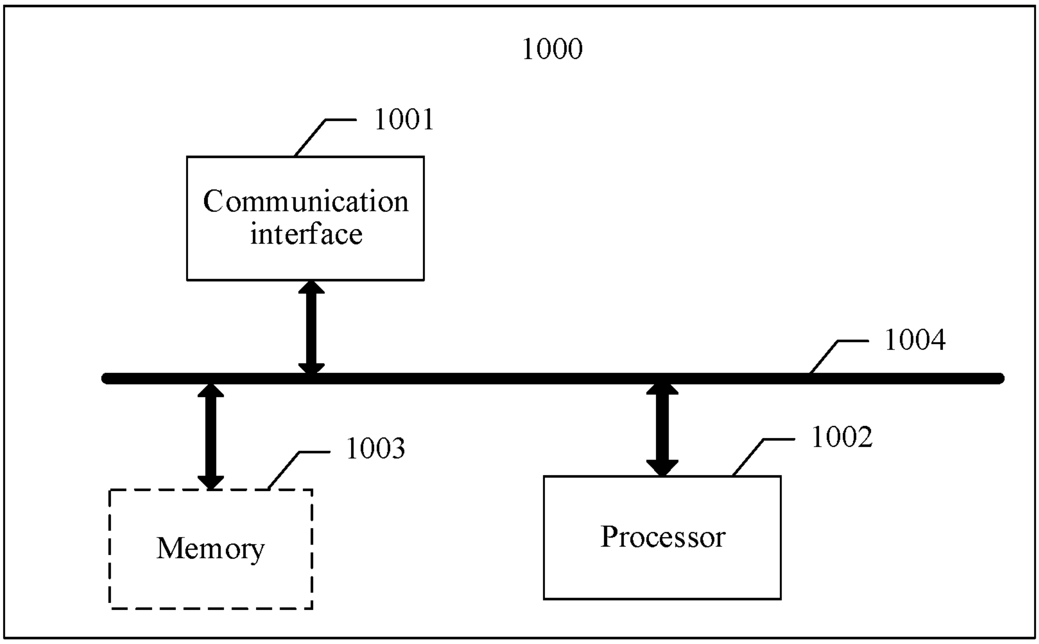
1000
1001
Communication interface
1004
1003
1002
Memory
Processor

FIG. 10

**INTERNATIONAL SEARCH REPORT**

International application No.
**PCT/CN2022/110969**

**A. CLASSIFICATION OF SUBJECT MATTER**

H04L27/00(2006.01)i;H04L1/00(2006.01)i

According to International Patent Classification (IPC) or to both national classification and IPC

**B. FIELDS SEARCHED**

Minimum documentation searched (classification system followed by classification symbols)

IPC：H04L

Documentation searched other than minimum documentation to the extent that such documents are included in the fields searched

Electronic data base consulted during the international search (name of data base and, where practicable, search terms used)

CNABS; CNTXT; CNKI; VEN; USTXT; EPTXT; WOTXT; 3GPP: 极化码, 极化编码, 信息比特, 长度, 子块, 数量, 个数, 分配, 序列, Polar Code?, information bit?, length, sub-block?, sub block?, number?, sequence, allocat+

**C. DOCUMENTS CONSIDERED TO BE RELEVANT**

| Category* | Citation of document, with indication, where appropriate, of the relevant passages | Relevant to claim No. |
|---|---|---|
| X | CN 114826478 A (HUAWEI TECHNOLOGIES CO., LTD.) 2022-07-29 (2022-07-29) description, paragraphs [0147]-[0324] | 1-3, 5, 12-14, 16, 24-30 |
| A | CN 113810061 A (HUAWEI TECHNOLOGIES CO., LTD.) 2021-12-17 (2021-12-17) entire document | 1-30 |
| A | CN 112313895 A (QUALCOMM INC.) 2021-02-02 (2021-02-02) entire document | 1-30 |
| A | US 2021075538 A1 (LG ELECTRONICS INC.) 2021-03-11 (2021-03-11) entire document | 1-30 |

☐ Further documents are listed in the continuation of Box C.　☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **04 April 2023** | **21 April 2023** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| Facsimile No. **(86-10)62019451** | Telephone No. |

Form PCT/ISA/210 (second sheet) (July 2022)

**INTERNATIONAL SEARCH REPORT**
**Information on patent family members**

International application No.
**PCT/CN2022/110969**

| Patent document cited in search report | Publication date (day/month/year) | Patent family member(s) | Publication date (day/month/year) |
|---|---|---|---|
| CN 114826478 A | 29 July 2022 | WO 2022161201 A1 | 04 August 2022 |
| CN 113810061 A | 17 December 2021 | WO 2021254422 A1 | 23 December 2021 |
| | | IN 202247076683 A | 06 January 2023 |
| CN 112313895 A | 02 February 2021 | US 2019393986 A1 | 26 December 2019 |
| | | US 11031958 B2 | 08 June 2021 |
| | | EP 3811543 A1 | 28 April 2021 |
| | | WO 2020005765 A1 | 02 January 2020 |
| US 2021075538 A1 | 11 March 2021 | WO 2019139412 A1 | 18 July 2019 |
| | | US 11411673 B2 | 09 August 2022 |

Form PCT/ISA/210 (patent family annex) (July 2022)